(19) Europäisches Patentamt
European Patent Office
Office européen des brevets

(11) EP 0 431 836 B1

(12) EUROPEAN PATENT SPECIFICATION

(45) Date of publication and mention
of the grant of the patent:
05.06.1996  Bulletin 1996/23

(51) Int Cl.6: **H01L 29/08**, H01L 29/73,
H01L 21/331

(21) Application number: 90312980.7

(22) Date of filing: 29.11.1990

(54) **Semiconductor device and electronic device by use of the semiconductor**

Halbleiterbauelement und elektronische Vorrichtung unter Verwendung des Halbleiters

Dispositif semi-conducteur et dispositif électronique utilisant le semi-conducteur

(84) Designated Contracting States:
**DE FR GB IT NL**

(30) Priority: 30.11.1989 JP 311548/89
30.11.1989 JP 311550/89
28.02.1990 JP 48320/90
28.02.1990 JP 48321/90

(43) Date of publication of application:
**12.06.1991  Bulletin 1991/24**

(73) Proprietor: **CANON KABUSHIKI KAISHA
Tokyo (JP)**

(72) Inventor: **Morishita, Masakazu,
c/o Canon Kabushiki Kaisha
Tokyo (JP)**

(74) Representative:
**Beresford, Keith Denis Lewis et al
BERESFORD & Co.
2-5 Warwick Court
High Holborn
London WC1R 5DJ (GB)**

(56) References cited:
**EP-A- 0 267 082**          **US-A- 4 672 413**

- **INTERNATIONAL ELECTRON DEVICES MEETING, Washington, Dec 4-6, 1978, IEEE, New York, US, pp. 333-335; H.C. de Graaff et al.: "The SIS Tunnel Emitter"**
- **PATENT ABSTRACTS OF JAPAN vol. 7, no. 17 (E-154) 22 January 83; & JP-A-57 176 762**

Remarks:
The file contains technical information submitted after the application was filed and not included in this specification

**Description**

BACKGROUND OF THE INVENTION

Field of the Invention

This invention relates to a semiconductor device and an electronic device by use of said semiconductor device, more particularly to a semiconductor device with a structure of bipolar transistor structure and an electronic device by use of said semiconductor device.

Related Background Art

There have been known in the art devices having thin films through which tunnel current flows as the emitter, such as bipolar transistor (BPT) with MIS structure, heterobipolar transistor (HBT) by use of micro-crystal ($\mu$C) or amorphous semiconductor as the emitter, etc.

In this case, in the above-mentioned BPT, by utilizing the difference in tunnel probability between electrons and positive holes, the positive holes from the base are impeded by the above-mentioned thin film, thereby effecting reduction of the base current.

However, in the case of the above-mentioned BPT, since the above-mentioned thin film through which tunnel current flows is used, the series resistance of the emitter becomes higher, whereby the reaction is generated between metal and insulation film, whereby reliability may be sometimes lacking. Particularly, since leak of base current occurs in low current region, it is difficult to effect increase of the current amplification ratio.

More specifically, the above-mentioned BPT with MIS structure of the prior art, for obtaining characteristics for effecting reduction of the above-mentioned base current, will require a necessary minimum thickness of the above-mentioned thin film, whereby the emitter resistance will be increased. On the contrary, if its thickness is too thin, the inhibition ratio of positive holes will be lowered, whereby no reduction of the base current can be effected to lower the current amplification ratio $h_{FE}$.

Further, since a difference occurs in tunnel probability between positive holes and electrons, positive holes cannot sometimes become carriers, and therefore although application to the npn type transistor may be possible, application to the pnp type transistor is difficult.

More specifically, in the case when the difference in transmittance of positive holes and electrons is small, inhibition of positive holes cannot be accomplished. Further, although utilization of such difference in transmittance may be applicable to an npn type transistor, it is not applicable to a pnp transistor which is different in junction type. The tunnel probability between positive holes and electrons is determined by the tunnel film, the thickness is sensitively reflected on the current amplification ratio $h_{FE}$, whereby variance will readily occur between individual transistors. Further, series resistance may vary similarly in some cases.

On the other hand, in HBT by use of micro-crystal ($\mu$C) of the prior art, the emitter-base junction, namely the interface between the emitter by use of $\mu$c-Si and the base is unstable, and in the low current region of base current, particularly recombination becomes prevailing, whereby the current amplification ratio $h_{FE}$ will be sometimes markedly lowered.

In the case of HBT by use of $\mu$C or HBT by use of an amorphous semiconductor as mentioned above, both are weak to heat treatment, thus sometimes lacking stability. Further, there sometimes ensure problems such that the reaction between $\mu$C or amorphous semiconductor and Si single crystal interface occurs, that the content of hydrogen is high to cause elimination phenomenon of said hydrogen to make the process unstable, or that deterioration may occur during actuation.

More specifically, in $\mu$c-Si of the prior art, addition of heat treatment will result in reduction of current amplification ratio $h_{FE}$ even at, for example, 450 °C. Preparation temperature of $\mu$c-Si is generally frequently 300 °C to 400 °C. Such reduction may be considered to be caused particularly by lowering in band gap and elimination of H (hydrogen) contained in $\mu$c-Si, etc. because of increased particle size of $\mu$c-Si at the Si interface. In $\mu$c-Si of the prior art, a large amount of hydrogen is contained during preparation thereof, and also $\mu$c-SiO is stabilized by the presence of hydrogen. The surrounding of $\mu$c-Si may be considered to be terminated with hydrogen.

In addition, interface defects may sometimes appear, because base current may be leaked in the fine current region, or hetero-junctions are present at the pn junction interface.

The BPT with MIS structure having the above-mentioned structure of the prior art is lowered in current amplification ratio $h_{FE}$ ($= I_C/I_B$) on the lower current side until, in an extreme case, it becomes 1 or less, particularly because the recombination current in the oxide film is predominant in the fine current region to increase the base current. In the case of such structure, the reaction between the metal and the insulation film is liable to occur, whereby reliability may be sometimes lacking. Further, since the insulation film has a considerable thickness, the series resistance has become large. Since the tunnel probability between positive holes and electrons is determined according to the thickness of the oxide film, the thickness is sensitively reflected on the above-mentioned $h_{FE}$, whereby characteristic variance of individual BPT occurs. The series resistance will also vary similarly. Thus, difficulties are accompanied with stable preparation of all the oxide films at A order.

On the other hand, in the HBT by use of $\mu C$ of the prior art, as described above, the emitter-base junction, namely the interface between the emitter by use of $\mu c$-Si and the base is unstable to heat treatment and susceptible to change, whereby stable preparation can be done with difficulty. This is because it is based on instability of the $\mu C$ itself or instability at the interface with the single crystalline silicon, and further containment of a large amount of hydrogen in ordinary $\mu C$ which further promotes instability of the crystal. In addition, one by use of $\mu C$ is susceptible to characteristic deterioration not only during preparation steps but also during actuation.

A publication of the International Electron Devices Meeting in Washington on December 4-6 1978, IEEE, New York at pages 333-335 discloses a semiconductor device which is provided with a thin insulator film between a monocrystalline emitter region and a polycrystalline layer laminated on the thin film. The purpose of the thin insulator film is to discriminate between electrons and holes as a means of reducing the base current. In this device appreciable electron current is provided as a tunnel current flow whilst the current flow of holes via the thin insulator film is inhibited.

US-A-4672413 discloses a bipolar transistor type semiconductor device in which the injection efficiency is greatly increased without significant increase in the emitter resistance of the transistor. To achieve this, an emitter tunnelling barrier is formed within the emitter region of the transistor rather than at the junction between the emitter and base regions. The emitter region adjacent to the barrier is heavily doped resulting in an increased injection efficiency, and the barrier is thin enough to preclude any significant increase in emitter resistance.

SUMMARY OF THE INVENTION

The present invention aims to alleviate some of the problems with the prior art semiconductor devices described above, and advantages of the present invention will become apparent to those skilled in the art from the following description of exemplary embodiments. For example, some embodiments provide a semiconductor device which (i) can maintain a high current amplification ratio over a broad range of collector currents; (ii) can withstand heat treatment; (iii) can inhibit an increase of base current in the low current region; and (iv) can be incorporated into a photoelectric conversion device.

According to a first aspect, the present invention provides a semiconductor device comprising: a collector region of first conductivity type; a monocrystalline base region of second conductivity type; a monocrystalline emitter region of the first conductivity type providing at an interface with the base region an emitter-base junction in single crystal; a thin film provided on the emitter region; and a polycrystalline layer laminated on the thin film; which semiconductor device is characterised in that: the thin film is so thin that it results in an appreciable tunnel current flow for both majority and minority carriers, the tunnelling probabilities of both majority and minority carriers being substantially equal to each other; and the polycrystalline layer provides a potential barrier to the flow of carriers injected from the base region thereby to reduce base current and increase current amplification ratio.

According to a second aspect, the present invention provides a photoelectric conversion device incorporating the above semiconductor device.

BRIEF DESCRIPTION OF THE DRAWINGS

Fig. 1 is a sectional view of a semiconductor device showing the first embodiment of the present invention;
Fig. 2A is a diagram showing the energy level of the polycrystalline layer when $Q_t > L \cdot Ni$;
Fig. 2B is a diagram showing distributions of crystal grain boundary $B_c$, depleted layer $E_P$ in a thin film N-type polycrystalline silicon;
Fig. 3A is a diagram showing the energy level of the polycrystalline layer when $Q_t > L \cdot Ni$;
Fig. 3B is a diagram showing distributions of crystal grain boundary $B_c$, depleted layer $E_P$ in a thin film N-type polycrystalline silicon;
Fig. 4 is a graph showing the relationship of specific resistance versus impurity concentration of polycrystalline layer;
Fig. 5 is a graph showing the relationship of height of potential barrier versus impurity concentration of polycrystalline layer;
Fig. 6 is a diagram showing the potential along the line A-A′ in Fig. 1;
Fig. 7A is a schematic view for illustration of the polycrystalline interface in the structure of the prior art;
Fig. 7B is a schematic view for illustration of the polycrystalline interface in the structure of the present invention;
Fig. 8A is an illustrative diagram showing the relationship between potential and distance for illustration of the tunnel film;

Fig. 8B is an illustrative diagram showing the relationship between potential and distance when a considerable voltage is applied on the tunnel film;

Fig. 9 is a graph showing the temperature characteristics of reciprocal number of the sheet resistance of a polycrystalline silicon;

Fig. 10A and Fig. 10B are diagrams showing the relationship between potential and distance for illustration of tunnel film;

Fig. 11 is a graph for comparison of relationships of voltage, current between the transistor of the present invention and the transistor of the prior art;

Fig. 12 is a graph showing the relationship between impurity concentration and life of positive holes in the emitter region;

Fig. 13A is an illustrative diagram showing the energy level of junction of n-type Si and n-type SiC;

Fig. 13B is an illustrative diagram showing the energy level of junction of n-type Si, n-type SiC, n-type Si;

Fig. 13C is an illustrative diagram showing the energy level of junction of n-type Si, n-type SiC of thin film, n-type Si;

Fig. 14 is a sectional view of a semiconductor device showing the second embodiment of the present invention;

Fig. 15 is a sectional view of a semiconductor device showing the third embodiment of the present invention;

Fig. 16 is a circuit diagram showing an embodiment of the electronic device by use of the semiconductor device according to the present invention;

Fig. 17A through Fig. 17D are views for illustration of quantization of the energy of electrons in polycrystalline layer;

Fig. 18 is a graph for illustration of the change of Fermi energy when electrons are packed in a cubic well;

Fig. 19 is a diagram showing the potential along the line A-A′ in Fig. 1;

Fig. 20 is a sectional view of a semiconductor device showing the fifth embodiment of the present invention;

Fig. 21 is a sectional view of a semiconductor device showing the sixth embodiment of the present invention;

Fig. 22 is a diagram showing the potential along the line A-A′ in Fig. 1 which is the emitter region;

Fig. 23 is a graph showing the relationship of carrier density versus normalized energy in semiconductor silicon;

Fig. 24 is a sectional view of a semiconductor device showing the eighth example of the present invention; and

Fig. 25 is a sectional view of a semiconductor device showing the ninth example of the present invention.

## DETAILED DESCRIPTION OF THE PREFERRED EMBODIMENTS

The present invention can effect reduction of base current in fine current region to obtain high current amplification ratio by preparing a thin film on the n$^+$ emitter region and further laminating a polycrystalline layer thereon, whereby polycrystalline layer will function as the barrier against positive holes.

By preparing the emitter-base junction in the single crystal, the base current can be reduced in the fine current region to obtain high current amplication ratio.

The thickness of the thin film prepared on the n$^+$ emitter region should be preferably made 5nm (50Å) or less. Its film thickness may be desirably as thin as possible. This is because, with thinner thickness, the series resistance in the emitter can be lowered, whereby positive holes can also give rise to tunnel phenomenon similarly as electrons.

By formation of a thin film which gives rise to tunnel phenomena of both positive holes and electrons on the emitter region, the series resistance in the emitter region is lowered.

By formation of a polycrystalline layer on said thin film, a barrier acting on both positive holes and electrons is formed, whereby reduction of base current can be effected.

Further, when the emitter-base junction is formed in the single crystal, increase of base current in fine current region can be inhibited.

In addition, by formation of a ultra-thin film on the emitter region, the tunnel probabilities of both positive holes and electrons become equal to each other, whereby increase of current amplification ratio can be realized.

By formation of a polycrystalline layer witha high impurity concentration on the ultra-thin film on the emitter region, a barrier of minority carriers injected from the base region is formed, which can contribute to reduction of base current to realize increase of current amplification ratio.

Further, since a polycrystal is formed through a ultra-thin film on the single crystal, it is stronger to heat as compared with the case when formed directly on the single crystal, and the grains size becomes constant to give also a stable interface.

By formation of a ultra-thin film, positive holes and electrons can be sufficiently tunneled, and therefore current and voltage characteristics of BPT are not affected by the oxide film.

More specifically, since the collector current is determined only by the base, and the value of the base current can be determined by the emitter impurity concentration, depth under the tunnel film, no change of h$_{FE}$ of BPT will occur depending on the thickness of the tunnel film.

In other words, a BPT with little variance having stable h$_{FE}$ can be obtained.

When an emitter-base junction is prepared in the single crystal, increase of the base current in fine current region can be inhibited.

Referring now to the drawings, preferred specific embodiments of the present invention are described in detail.

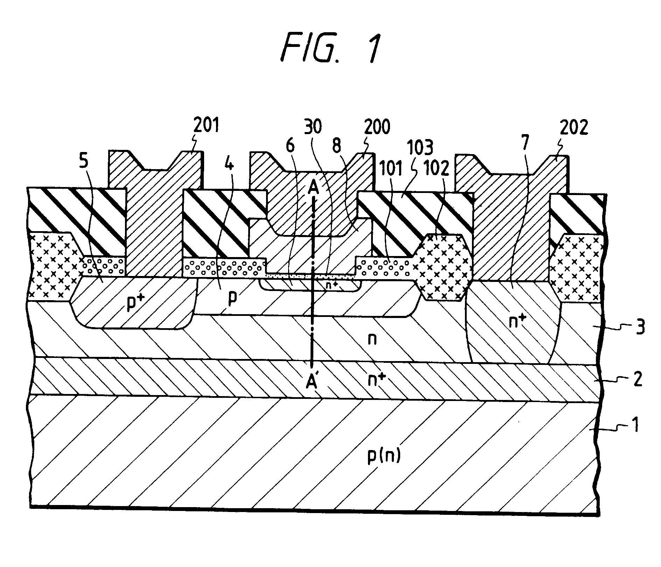

Fig. 1 shows the first embodiment according to the semiconductor device of the present invention.

In the same Figure, 1 is a silicon substrate, and said substrate 1 is an n-type substrate which has been made n-type by doping of an impurity such as phosphorus (P), arsenic (As), antimony (Sb), etc. or a p-type substrate which has been made p-type by doping of an impurity such as boron (B), aluminium (Al), gallium (Ga), etc.

2 is an n$^+$ region (n$^+$ embedded region), and said first n$^+$ embedded region 2 may be preferably made to have an impurity concentration of $10^{16}$ to $10^{20}$ [cm$^{-3}$].

3 is an n region as a part of the collector region, and said n region 3 is a region with a low impurity concentration (e.g. about $10^{13}$ to $5 \times 10^{17}$ [cm$^{-3}$]) formed by epitaxial technique, etc.

4 is a p-type region as the base region, and said p-type region 4 may be preferably made to have an impurity concentration of $10^{15}$ to $10^{20}$ [cm$^{-3}$].

5 is a P$^+$ region, and said P$^+$ region 5 is provided for lowering the base resistance and may be preferably made to have an impurity concentration of $10^{17}$ to $10^{20}$ [cm$^{-3}$].

6 is a first n$^+$ emitter region.

7 is a second n$^+$ region, and said second n$^+$ region is provided for connecting the collector electrode 202 as described below to the above-mentioned embedded region 2 which is the n$^+$ region so as to lower the collector resistance.

8 is a polycrystalline layer which is a semiconductor material layer. Said polycrystalline layer 8 impedes the carriers injected from the base.

30 is a thin film. Said thin film 30 is provided for flowing tunnel current.

101, 102, 103 are insulating films for separation between the electrodes, elements and wirings.

200, 201, and 202 are respectively emitter electrode, base electrode and collector electrode, and the respective electrodes 200, 201 and 202 are formed of metals, silicides, etc.

The above-mentioned thin film 30 is made thinner than the film of the MIS type BPT of the prior art. At least positive holes will become the carriers of current. The positive holes passed through said thin film 30 are impeded by the polycrystalline layer 8.

In the following, the above-mentioned polycrystalline layer 8 is described.

Polycrystal is a mass of single crystals having a distribution of a certain size, and those crystal grains have no constant crystal direction. They have also crystal grain boundaries, and remarkable disorders of lattices occur at those portions. Therefore, presence of crystal grain boundary is the cause of having electrical characteristics different from single crystal.

The above-mentioned electrical characteristics are greatly influenced by the crystal grain size and the lattice defect density of the crystal grain boundary. The lattice defect existing at said crystal grain boundary becomes the capturing centre of free carriers as deep acceptor or donor level to capture charges in forbidden gap. By such capturing, a depleted layer region arises around the crystal grain boundary to change the potential, and the change of said potential will act like a barrier against the carriers.

Polycrystal is changed in its characteristics depending on its grain size L [cm], the impurity concentration Ni [cm$^{-3}$], the trap level density $Q_t$ at the crystal grain boundary [cm$^{-2}$], and referring to polycrystalline silicon as an example, said characteristic change is described below.

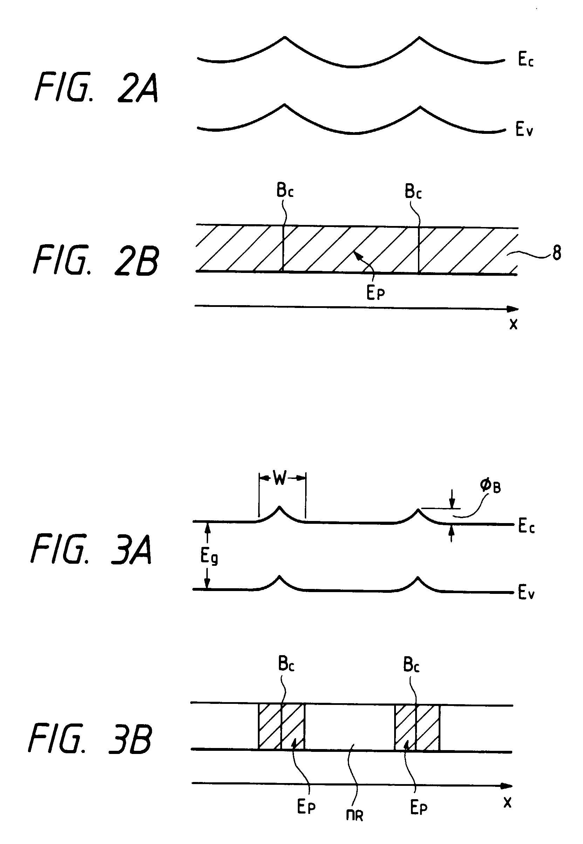

Figs. 2A, 2B show the energy band diagram when $Q_t > L \cdot Ni$ (Fig. 2A), and spreading of the crystal grain boundary $B_c$, the depletion layer $E_P$ in the thin film N-type polycrystalline silicon (Fig. 2B).

Figs. 3A, 3B show the energy band diagram when $Q_t < L \cdot Ni$ (Fig. 3A), and spreading of the crystal grain boundary $B_c$, the depletion layer $E_P$ in the thin film N-type polycrystalline silicon (Fig. 3B).

More specifically, as shown in Fig. 2B, when $Q_t > L \cdot Ni$, the polycrystalline silicon is internally all depleted. On the other hand, as shown in Fig. 3B, when $Q_t < L \cdot Ni$, the depletion layer region spreads only to the vicinity of the crystal grain boundary, thus representing the state wherein neutral region remains in polycrystalline silicon. In other words, resistance will be extremely higher when $Q_t > L \cdot Ni$.

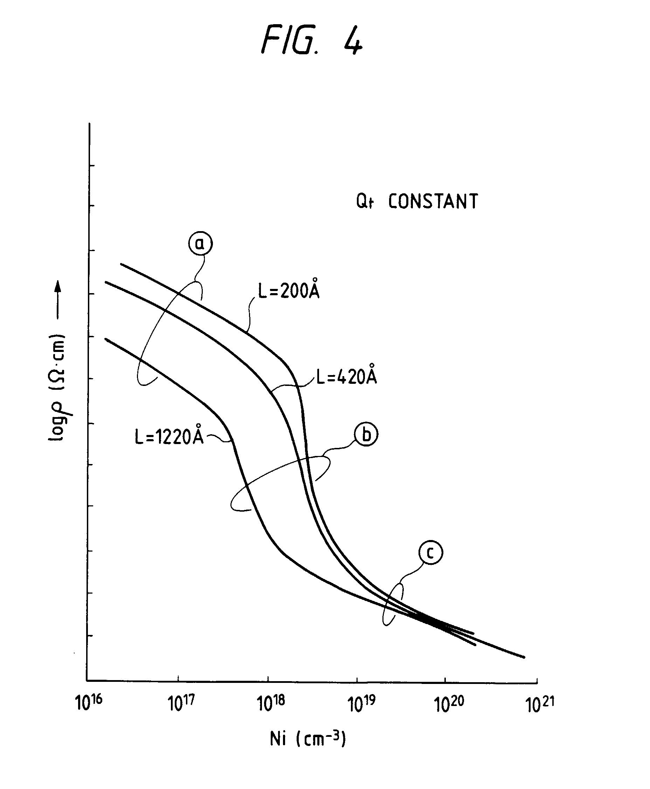

Fig. 4 shows an example of specific resistance $\rho$ versus impurity concentration Ni in the case when the trap level density $Q_t$ is made constant, and the grain size L is varied as: 20; 42; 122nm (200 Å, 420 Å, 1220 Å).

Here, the region (a) represents the case of $Q_t > L \cdot Ni$ and the region (b) the case of $Q_t < L \cdot Ni$.

The region (c) is the case when the impurity concentration is high and the barrier $\phi_B$ shown in Fig. 3A becomes extremely thin, and because the carriers pass through the barrier by tunnel phenomenon, there becomes substantially no barrier, whereby the region will have a specific resistance approximate to single crystal.

The above-mentioned regions (a), (b) are specific characteristic regions of a polycrystal body, but the region (a) has too high resistance and is not suitable for the semiconductor device.

In the present embodiment, it is desirable to use the polycrystal body of the above-mentioned region (b) for the emitter region of the BPT.

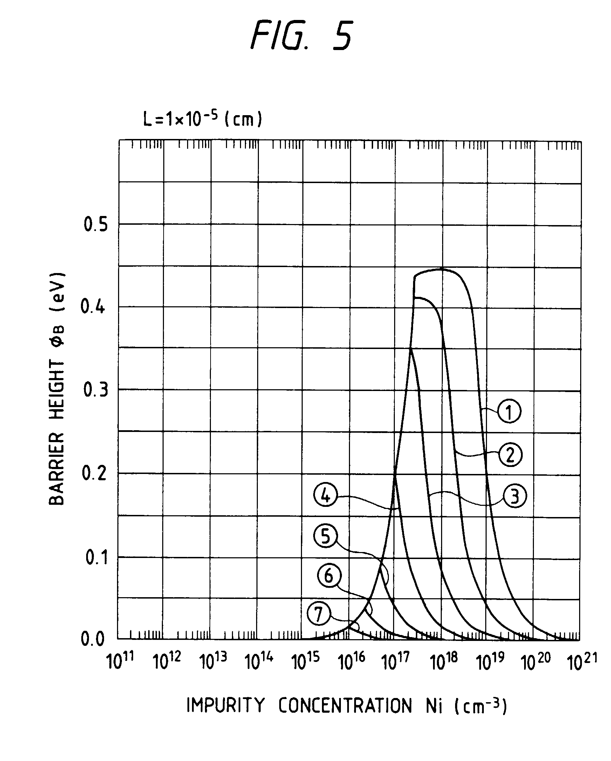

It is difficult to measure actually how high is the barrier in the above-mentioned (b), and therefore, as shown in Fig. 5, an example determined by calculation is shown.

That is, with the crystal grain size being made constant as $L=10^{-5}$ [cm], and the respective values of the trap level density $Q_t$ (the respective values corresponding to (1) to (7) in Fig. 5 of $1 \times 10^{-13}$, $5 \times 10^{-12}$, $2 \times 10^{-12}$, $1 \times 10^{-12}$, $5 \times 10^{-11}$, $2 \times 10^{-11}$, $1 \times 10^{-11}$) being respectively as parameters, the height $\phi_B$ of the above-mentioned barrier is plotted versus impurity concentration Ni [cm$^{-3}$].

According to the experimental data, the $Q_t$ of the polycrystal according to the present embodiment has a value of about $1 \times 10^{-12}$ to $1 \times 10^{-13}$ [cm$^{-2}$], while the grain size of ordinary crystal is 200 to 1000 [Å], and therefore the height of the barrier $\phi_B$ may be considered to have ordinarily a value as shown in Fig. 5. Therefore, the maximum value of the height of the barrier $\phi_B$ may be sometimes about 0.45 [eV]. However, it is required that the grain size L, the trap level density $Q_t$ at the interface, the impurity concentration Ni should be optimized.

The current flowing through the region (b) of the polycrystal becomes a hot electron radiation type as one with the carriers flowing over the barrier $\phi_B$.

On the other hand, the width W of the depletion layer $E_P$ (see Fig. 3A) is represented approximately by:

$$W = \frac{Q_t}{N_i} \tag{1}$$

For example, if $Q_t = 5 \times 10^{-12}$ [cm$^{-2}$] and Ni is $10^{18}$ [cm$^{-3}$],

$$w = 5 \times 10^{-6} \text{ [cm]}$$

$$= 50 nm \ (500 \text{ Å}),$$

and $\phi_B$ of about 0.35 [eV] will occur. As shown in Fig. 3, if L=100nm (1000 Å), the neutral region $n_R$ of 50nm (500 Å) would remain.

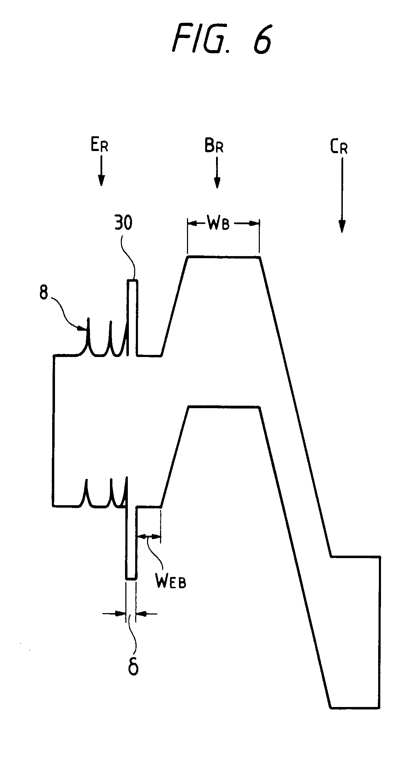

Fig. 6 shows the potential diagram at the cross-section A-A' in Fig. 1. In the same Figure, $E_R$ represents emitter region, $B_R$ base region and $C_R$ collector region.

In the Figure, $W_B$ represents the neutral region width of the base, $W_{EB}$ the neutral region width of the emitter in the single crystal, and $\delta$ the thickness of the above-mentioned thin film 30.

The greatest characteristic function of the above-mentioned thin film 30 is to separate the polycrystalline layer 8 from the first n$^+$ region 6 which is the single crystal in the emitter region 6, simultaneously with flattening of its interface, and also stabilize the polycrystal layer 8.

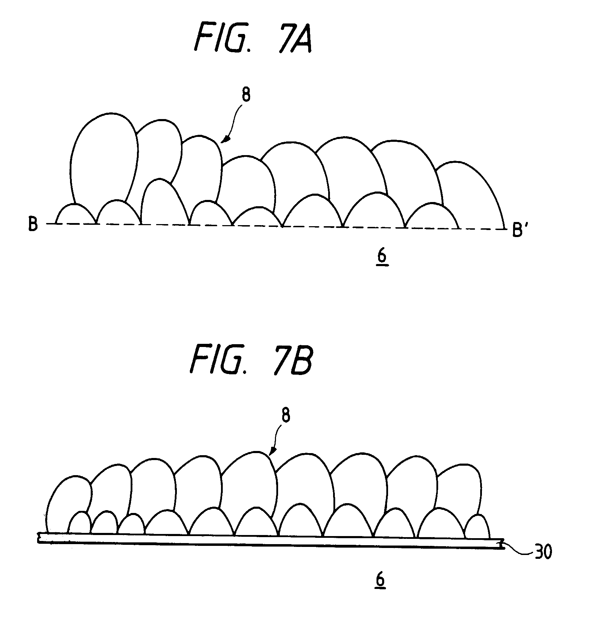

More specifically, for example, if the polycrystal layer 8 is deposited directly on the n$^+$ region 6 which is merely a single crystal with the structure of the prior art as shown in Fig. 7A, the crystal with about the grain size of a polycrystal is grown epitaxially on the single crystal, whereby the inherent interface with the single crystal (B - B' in Fig. 7A) is changed to become wavy and cannot maintain always a constant shape. In this case, if a polycrystal is deposited on a naturally oxidized film and subjected to heat treatment, the oxide film may be sometimes broken and epitaxial growth may locally occur. In an extreme case, the naturally oxidized film will become shaped like ball, and the polycrystal recrystallized into single crystal.

Thus, in the case of the structure of prior art, none of the interfaces between single crystal and polycrystal is flat, thereby causing variance of characteristics of BPT to occur.

More specifically, when the carriers injected from the base into the emitter are recombined in the emitter, the emitter will become internally nonuniform, and therefore in the individual BPT prepared, the base current value is not constant, but variance will become greater between the respective BPT.

In the present embodiment as shown in Fig. 7B, the thin film 30 is prepared on the first n$^+$ region 6 which is a single crystal, the polycrystal layer 8 is formed on said thin film (silicon oxide film in the present embodiment), and therefore its interface is flat on the atomic order. The polycrystal layer 8 is deposited through the stable thin film 30, and therefore rearrangement of the polycrystal by heat treatment will not readily occur, and it is also stable in the later heat treatment. In micro-crystal Si, amorphous Si, etc. of the prior art (deposition temperature 100 to 300 °C), the characteristics changed easily by heat treatment at 400 to 600 °C, whereby deterioration of current amplification ratio $h_{FE}$ will readily occur.

In the present embodiment because the crystal is a polycrystal, its deposition temperature is higher, for example, about 550 to 650 [°C] in the case of polycrystalline Si, and therefore in addition to greater crystal grain size, substantially no hydrogen is contained, with the crystal size in the later steps being little, and yet substantially without change by elimination of hydrogen. In the case of polycrystalline Si, it can sufficiently stand a temperature up to about 900 [°C] and an extremely stable BPT can be obtained.

The interface of the polycrystal layer 8 exists at the interface with the thin film 30, and therefore the interface with the emitter region which is a single crystal becomes extremely flat. This is an extremely important factor for stabilizing the BPT characteristics.

As is apparent from the above description, the material of the above-mentioned thin film 30 is required to be stable, and may be desirably chemically stable materials such as $SiO_2$, $Si_3N_4$, SiC, $Al_2O_3$, etc. To add further, the interface between the thin film 30 and the single crystal is also extremely important, and the recombination level at the interface is required to be low.

As shown in Fig. 6, within the polycrystal layer 8, a convex potential barrier against electrons is formed. On the other hand, a concave potential barrier is formed against positive holes.

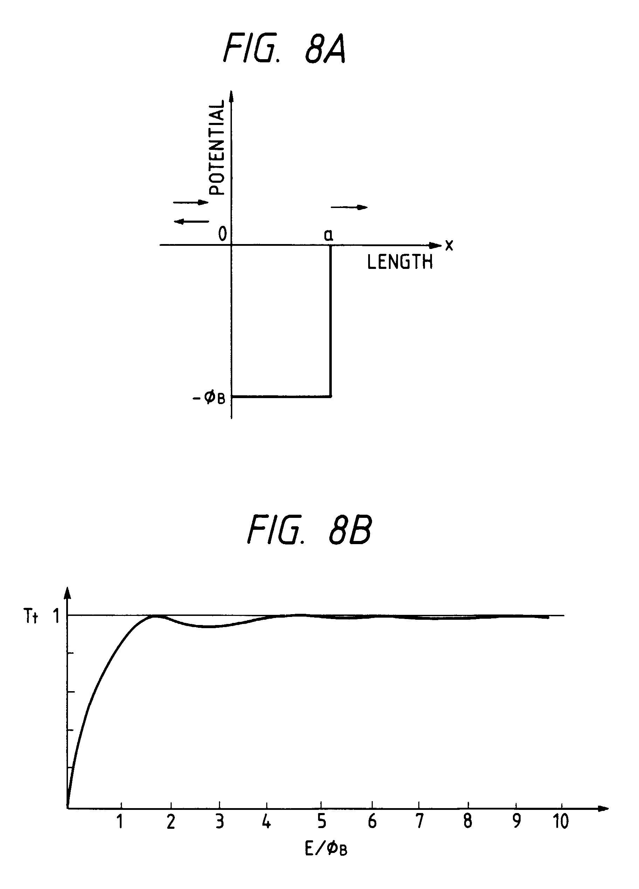

As shown in Fig. 8A, when the depth of potential well is defined as $-\phi_B$, and the width as $\underline{a}$, the transmission probability $T_{th}$ of the carriers is:

$$T_{th} = [1 + \frac{\phi Bh^2 \sin^2 \alpha a}{4E(E + \phi_B)}]^{-1} \tag{2}$$

where

$$\alpha = [\frac{2m^* (\phi_{Bh} + E)}{\hbar^2}]^{1/2}$$

As an example, if $m^* \phi_{Bh} a^2 / \hbar^2 = 8$, the transmission probability $T_{th}$ will be as shown in Fig. 8B. Here, E is the energy of electrons, and when $E/\phi_{Bh} < 1$, transmission probability is markedly lowered. Since E is generally about kT, the positive hole impeding effect occurs when $\phi_B > kT$.

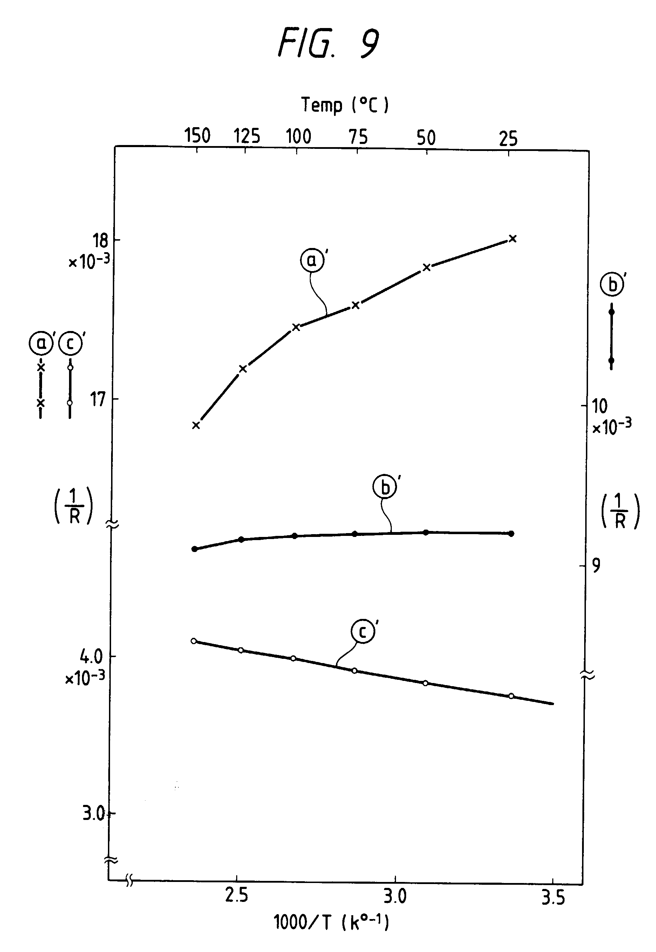

Fig. 9 shows the characteristics of reciprocal number (electro-conductivity) of the sheet resistance R of the polycrystalline silicon practiced in the present embodiment versus reciprocal number of temperature T.

In the case of (a)′, the impurity concentration of polycrystalline silicon is the highest, and then the concentration becomes lower in the order of (b)′, (c)'. In this case, the deposition temperature, the thickness, the heat treatment are the same conditions.

In (b) ', (c) ', the potential as previously mentioned arises, and the mechanism of current flow becomes predominantly hot electron radiation type, whereby characteristics are changed. Improvement of the BPT characteristics is effective if at least 1/R is flat versus temperature, or 1/R is increased by temperature elevation.

As contrasted to the emitter by use of the polycrystalline silicon of (a)', the BPT by use of the polycrystalline silicon of (b)', (c)' is reduced in base current successively as 2/3, 1/3. Accordingly, $h_{FE}$ becomes respectively 1.5- and 3-fold.

As shown in Fig. 1, the first $n^+$ region 6 is formed within a single crystal. In the case of determining base current, the first $n^+$ region 6 also becomes an extremely important factor.

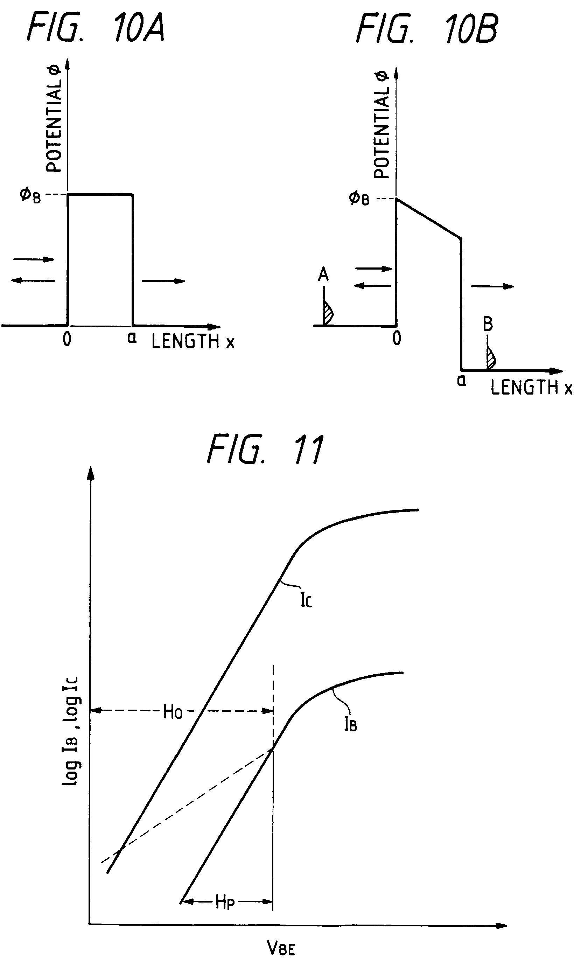

Next, the above-mentioned tunnel effect is to be described. When electrons from the semiconductor material layer 8 pass through the emitter region $E_R$ shown in Fig. 6, it can be described by referring to a model of barrier potential as shown in Fig. 10A. Here, when $\phi_B$ is defined as the barrier height and $\underline{a}$ as the barrier width, the tunnel probability $T_{te}$ of the electron with an energy E having an effective mass $m^*$ becomes as follows from the Schrodinger's wave equation:

$$T_{te} = [1 + \frac{\phi_B^2 \sinh^2 \beta a}{4E(\phi_B - E)}]^{-1} \tag{3}$$

wherein

$$\beta = [\frac{2m^* (\phi_{Be} - E)}{\hbar^2}]^{1/2} \tag{4}$$

Here, if $\phi_B \gg E$, $\beta a \ll 1$, $T_t$ becomes as follows:

$$T_t \simeq 16 \frac{E}{\phi_B} \exp(-2\beta a) \tag{3'}$$

wherein

$$\beta \simeq (2m^* \phi_B)^{1/2} / \hbar \tag{4'}$$

Next, when a voltage is applied, the potential becomes inclined in the thin film 30 as shown in Fig. 10B, whereby the tunnel probability $T_t$ is increased.

Here, the total tunnel current $I_{et}$ may be speculated as follows:

$$I_{et}$$

$$= A \int_{EC}^{\infty} F_{c1}(E) n_{c1}(E) T_{te} (1-F_{c2}(E)) n_{c2}(E) dE$$

$$\ldots \quad (5)$$

In the above formula, A is a constant, $T_t$ the tunnel probability in the above formula (1) , $F_{c1}$, $F_{c2}$ are Fermi-Dirac distribution functions of the above-mentioned semiconductor material layer 8 and the emitter region $E_R$, and $n_{c1}$, $n_{c2}$ represent the state densities of the conduction bands of said both materials.

In the foregoing formula (4), when $\phi_B \gg E$, the item concerned with the thickness of the thin film 30 comes outside of the object to be integrated, becoming as follows:

$$I_{et}^{\infty} \ exp \ (-2\beta a)$$

whereby it can be understood that an exponential functional effect occurs in the thickness of the thin film 30. Thus, the thickness contributes most greatly to the electron tunnel current $I_{et}$.

In the foregoing formula (5), another important item is the following item:

$$F_{c1}(1 - F_{c1})$$

wherein $F_{c1}$ denotes a probability of existence of electron at a side of A. $(1-F_{c2})$ denotes a probability of an inexistence of electron at a side of B, and a product thereof greatly effects a probability of an electron transition, but for increasing the item of this product, a voltage corresponding to about kT or higher may be applied on the thin film 30, and, for example, it may be about 0.025 V at room temperature.

In the case of BPT, the voltage drop in the above-mentioned thin film 30 is about the above-mentioned voltage value and, as shown in Fig. 10B, during voltage application, the existing probability is shifted in energy as shown by A, B, whereby in the energy band having the same energy as the energy of electrons on side of the semiconductor material layer 8 (the left side in Fig. 10B), there exists no electron on the emitter side (right side in Fig. 10B) and transition of electrons can be readily effected. Also, by voltage application on the thin film 30, the barrier height is slightly reduced.

In the present embodiment, as shown in Fig. 6, both the thickness $W_{EO}$ of the emitter region $E_R$ and the concentration Ni are important factors for reducing the base current.

Usually, the above-mentioned thin film 30 has a thickness of 5nm (50 Å) or less, which is comparatively smaller as compared with the thickness of the n+ emitter region 6, and the distance $W_E$ from the emitter-base junction portion to the polycrystal layer 8 is represented by:

$$W_E \simeq W_{EO} + \delta$$

and becomes substantially equal to $W_{EO}$.

On the other hand, another important factor in the present embodiment, namely inhibition of minority carriers injected from the base, is effected at the interface between the polycrystal layer 8 and the thin film 30. Of course, since the tunnel probability for electrons and positive holes in the thin film 30 is greater for electrons, the reduction effect of the base current by positive holes is obtained as the overlapping action of the both.

Next, the constituents of the current of the above-mentioned BPT are to be described.

The collector current $J_c$ is approximately represented by the following formula (6):

$$J_c = \frac{q \cdot D_n \cdot n_i^2}{N_B \cdot W_B} \{\exp(\frac{V_{BE}}{kT}) - 1\} \tag{6}$$

wherein the diffusion distance is made longer than the base width. $N_B$ is the base concentration, $W_B$ the base width, $D_n$ the diffusion distance of electrons, $n_i$ the intrinsic carrier density of Si and $V_{BE}$ the base-emitter applied voltage.

On the other hand, the base current comprises the recombination current $J_{Brec}$ in the base and the diffusion current $J_{Bdiff}$ of the positive holes injected from the base into the emitter.

Here, the recombination current $J_{Brec}$ is represented by:

$$J_{Brec} = \frac{q \cdot D_n \cdot n_i^2 \cdot W_B}{2N_B \cdot L_n^2} \{\exp(\frac{V_{BE}}{kT}) - 1\} \tag{7}$$

wherein $L_n$ is the diffusion distance of electrons.

Shortly speaking, in the homo-junction type BPT of the prior art, $J_{Bdiff}$ is the main component, and no high current gain can be obtained.

The diffusion current $J_{Bdiff1}$ in the homo-BPT of the prior art when the diffusion length $L_P$ of the positive holes is smaller than the emitter thickness $W_E$ (case 1) ($L_P << W_E$) is represented by:

$$J_{Bdiff1} = \frac{q \cdot D_P}{L_P} \cdot \frac{n_i^2}{N_E} \{\exp(\frac{V_{BE}}{kT}) - 1\} \qquad (8)$$

On the other hand, when shallowing of the emitter junction accompanied by higher integration is effected, the relationship becomes $L_P >> W_E$ (case 2), whereby the diffusion current $J_{Bdiff2}$ is represented by:

$$J_{Bdiff2} = \frac{q \cdot D_P}{W_E} \cdot \frac{n_i^2}{N_E} \{\exp(\frac{V_{BE}}{kT}) - 1\} \qquad (9)$$

Therefore, the diffusion current becomes further greater, whereby the current amplification ratio $h_{FE}$ of BPT is reduced.

In the case of the present embodiment, when the recombination speed at the hetero-interface is made a negligible value, the diffusion current $J_{Bdiff3}$ is represented by the following formula (10) ($L_P >> W_E$):

$$J_{Bdiff3} = \frac{qD_P \cdot W_E}{L_P^2} \cdot \frac{n_i^2}{N_E} \{\exp(\frac{V_{BE}}{kT}) - 1\} \qquad (10)$$

In BPT of the present embodiment, in the above-mentioned case 1, the diffusion current $J_{Bdiff}$ becomes $W_E/L_P$-fold relative to the homo-junction form BPT of the prior art.

Further, for the above-mentioned case 2, the diffusion current $J_{Bdiff}$ becomes $(W_E/L_P)^2$-fold.

Thus, in the present embodiment, the diffusion current $J_{Bdiff}$ can be dramatically reduced. In other words, the current amplification ratio $h_{FE}$ can be dramatically increased.

In the MIS structure BPT of the prior art, there exists no diffusion $J_{Bdiff}$ because $W_E=0$, but other current components exist.

Fig. 11 is a graph showing schematically the current-voltage characteristics of the transistor, the axis of abscissa showing the applied voltage between the base-emitter, the axis of ordinate the base current $I_B$ and the collector current $I_C$ represented in logarithmic values. In the BPT of the present embodiment, the collector current $I_C$ and the base current $I_B$ become substantially in parallel to each other, and also in the fine current region ($H_P$), the current amplification ratio $h_{FE}$ ($=I_C/I_B$) becomes a constant value. In the MIS structure BPT of the prior art, excessive current flows in the fine current region ($H_O$).

The base current in the BPT according to the present embodiment is primarily the recombination current represented by the above formula (7), and the maximum value $h_{FEmax}$ of the current amplification ratio in this case is as follows:

$$h_{FEmax} = (L_n/W_B)^2 \qquad (11)$$

and the upper limit of $h_{FE}$ is determined only by the base conditions. According to the present embodiment, $h_{FE}$ can be made 10000 or higher.

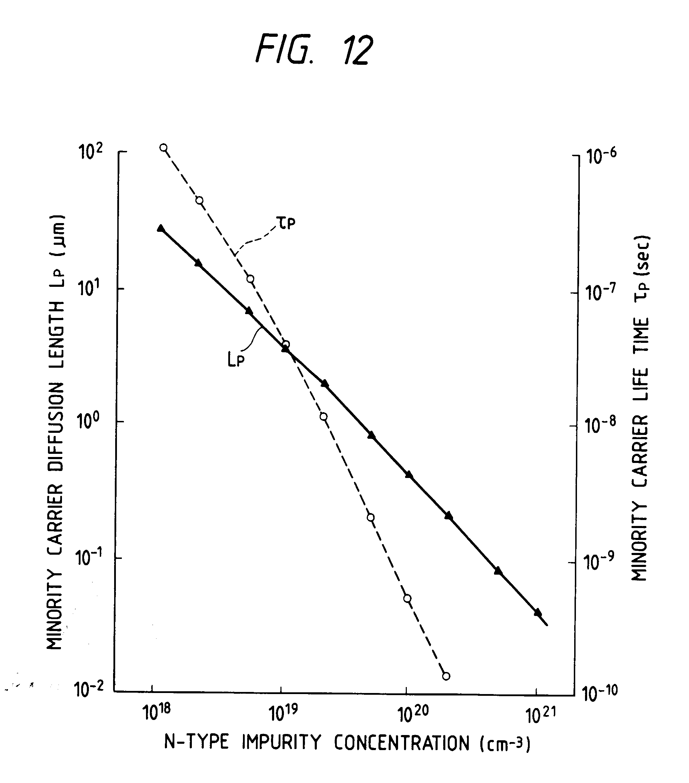

Fig. 12 shows the relationships between the impurity concentration in the above-mentioned $n^+$ emitter region 6 and the diffusion distance $L_P$ of the minority carriers (positive holes) and the life $\tau_P$ of said minority carriers (positive holes). From the condition determined by the formula (10), it is preferable that the emitter depth should be made at least about 1/5 of the diffusion distance of positive holes.

Next, the preparation process of the semiconductor device shown in Fig. 1 is to be described.

(1) On a substrate 1 of a predetermined conduction type (p-type or n-type) is formed an $n^+$ embedded region 2 with an impurity concentration $10^{15}$ to $10^{19}$ [cm$^{-3}$] by ion injection (or impurity duffusion, etc.) of As, Sb, P, etc.

(2) By epitaxial technique, etc. an n-type region 3 with an impurity concentration of $10^{14}$ to $10^{17}$ [cm$^{-3}$] is formed.

(3) An $n^+$ region 7 for reducing the resistance of the collector (with an impurity concentration of $10^{17}$ to $10^{20}$ [cm$^{-3}$]) is formed.

(4) An insulation film 102 for element separation is prepared by the selective oxidation method or the CVD method, etc.

(5) In the active region, a $p^+$ region 5 and a p region 4 which is the base region are formed by the ion injection method, etc.

(6) After opening of an emitter contact on the insulation film 101, an $n^+$ emitter region doped with As, Sb, P, etc. (impurity concentration $5 \times 10^{17}$ to $5 \times 10^{20}$ [cm$^{-3}$]) 6 is formed by the ion injection method or the thermal diffusion method.

(7) A thin film 30 is prepared by oxidation at lower temperature of 500 °C to 650 [°C] or by thermal oxidation by rapid thermal acceleration (RTA).

(8) After deposition of a polycrystalline Si doped to $n^+$ according to the LPCVD (Low Pressure Chemical Vapor Deposit ion) method, and introduction of impurities by ion injection, diffusion, etc., it is subjected to patterning.

(9) An insulation film 103 is deposited, which is annealed and then subjected to opening of contact.

(10) An Al-Si (1 %) which becomes the electrode 200 is subjected to sputtering, followed by patterning of the Al-Si.

(11) After alloy formation of the Al-Si electrode, a passivation film is formed.

According to the procedure as described above, an MIS structure BPT is completed.

As the above-mentioned thin film 30, a silicon oxide film is the optimum, because it can be easily formed at low temperature, but an insulation film such as silicon nitride film, alumina film, etc. may be also employed.

Also, by use of SiC, etc., a structure which becomes the tunnel type barrier may be formed. For example, single crystal SiC, as compared with Si has a conduction band energy difference $\Delta Ev=0.53$ [eV], a valence electron band difference $\Delta EC=0.55$ [eV] and a band gap $Eg=2.2$ [eV], and when both SiC and Si are junctioned stepwise in n-type, it becomes to have a structure different from the semiconductor/insulator junction.

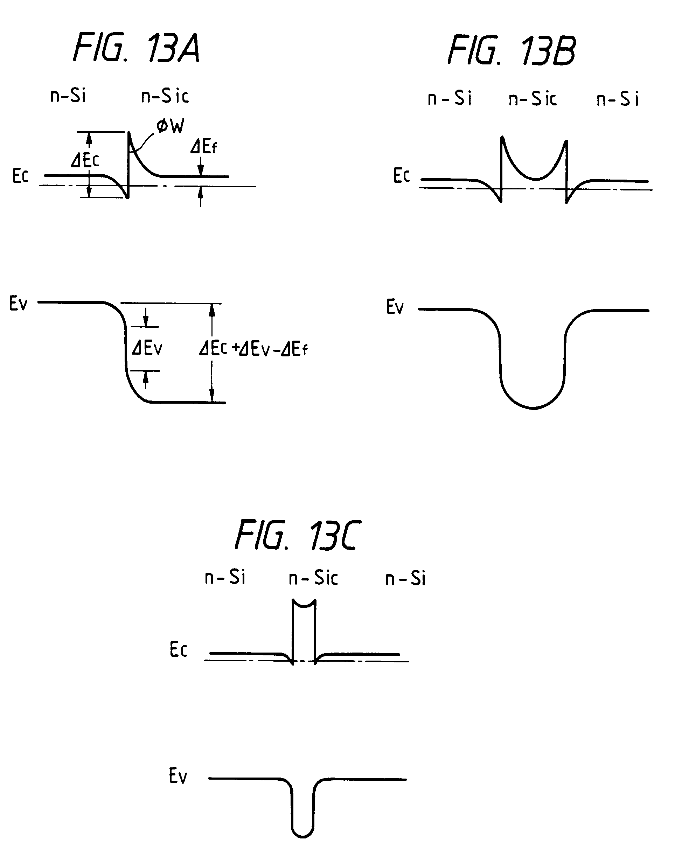

Fig. 13A, 13B, 13C each show a band structure of hetero-junction mutually of the same conduction type (n-type in this case), namely the isotype.

Fig. 13A shows the junction of the n-type Si and the n-type SiC, $\Delta EC$, $\Delta EV$ appearing respectively above and below, and a barrier $\phi_W$ called notch being formed on the conduction band side, while on the valence electron side, an energy difference of the following is created:

$$\Delta Ec + \Delta Ev - \Delta Ef \qquad (12)$$

On the other hand, by junction of the n-type Si, the n-type SiC and the n-type Si, the energy level becomes as shown in Fig. 13B.

Further, by forming SiC into a thin film, the SiC will be depleted to become similar to an insulation material, whereby the energy level becomes as shown in Fig. 13C.

With the structure shown in Fig. 13C, the electron current can be made-greater. In Fig. 13A to Fig. 13C, an example using SiC is shown, but it will be apparent that other materials with broad forbidden band gap can be also employed.

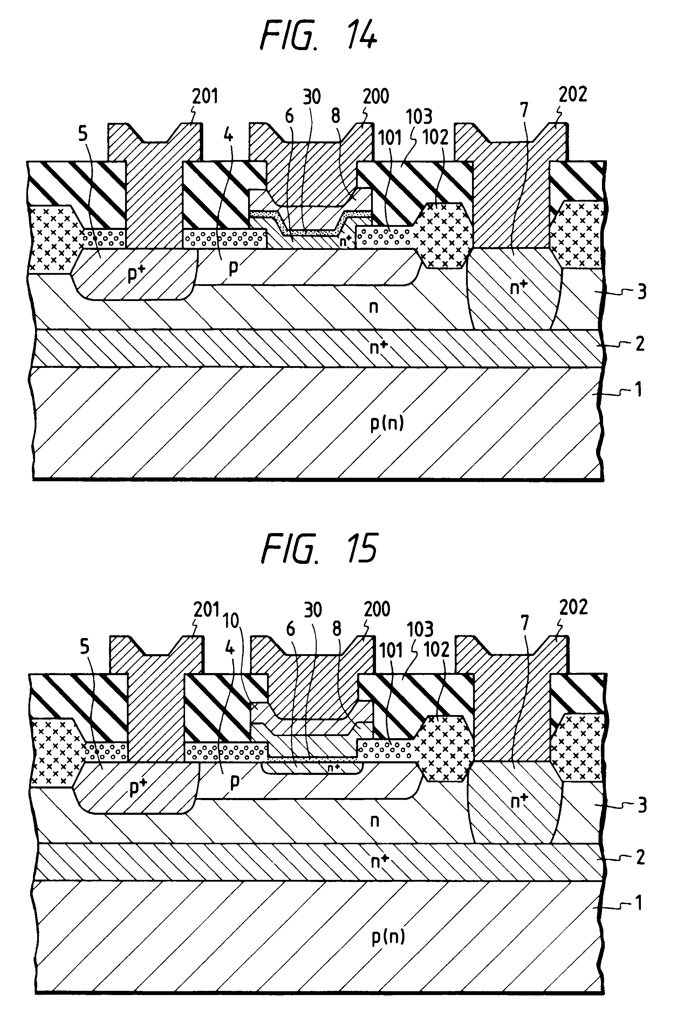

Fig. 14 shows a second semiconductor device according to the second embodiment of the present invention. In this embodiment, an emitter region 6 is formed by epitaxial growth on the base region (p-type region 4), and on the emitter region 6 is formed a thin film 30 for tunnel. By making such structure, it becomes that there is no carrier diffused therearound due to no area distributed within base, whereby it becomes possible to obtain a current amplification ratio which is approximate to the above-mentioned maximum amplification ratio $h_{FEmax}$.

Next, Fig. 15 shows the third embodiment of the semiconductor device of the present invention, and this embodiment is different from the above-described first embodiment in that a semiconductor material layer 8 is formed on the thin film 30 and a semiconductor layer 10 of a material with narrower forbidden band gap than said semiconductor material layer 8 is further formed on said semiconductor material layer 8. With such construction, ohmic resistance between the emitter and the metal is improved. If the semiconductor material layer 8 is a polycrystalline or amorphous SiC, the semiconductor layer 10 should be preferably selected as Si, while if the semiconductor material layer 8 is Si, it is desirable that Ge, etc. should be used as the semiconductor layer 10.

The conduction type of the semiconductor layer 10 is the same as that of the semiconductor material layer 8.

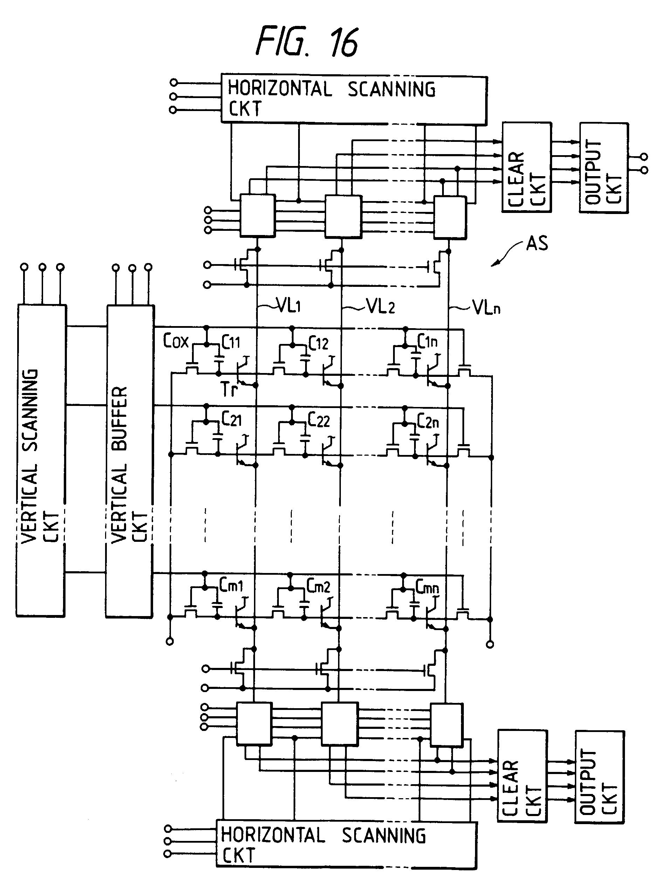

Fig. 16 is a circuit example showing an example of the electronic device as an application example of the semiconductor device according to the above-mentioned embodiment. It shows the case when the BPT shown in the above-described embodiment 1 is used in the solid image pick-up device disclosed by the present Applicant in Japanese Patent Application No. 62-321423.

More specifically, in Fig. 16, the transistor Tr constituting the sensor cells $C_{11}$, $C_{12}$, ... $C_{mn}$ of the area sensor AS employs the MIS type BPT shown in the above-described first embodiment.

When the area sensor AS shown in Fig. 16 is used as a colour camera, the actuation of reading optical informations of the same photoelectric converting device for plural times is performed. In this case, for reading for plural times from the same element, the ratio of the electrical output during the first reading to that during the second reading and thereafter is a problem, and correction is required when the value of this ratio has become smaller.

When the ratio of the first reading output to the second is defined as the non-destruction degree, the non-destruction degree is represented by the following formula:

$$\text{Non-destruction degree} = (C_{tot} \times h_{FE}) / (C_{tot} \times h_{FE} + C_v) \qquad (13)$$

Here, $C_{tot}$ indicates the total capacity of the transistor Tr connected to the base shown in Fig. 16, which is determined by the base-collector capacity $C_{bc}$ and $C_{ox}$. $C_v$ is the floating capacity of the reading line shown by $VL_1$, ... $VL_n$. However, $C_{ox}$ may not sometimes exist depending on the circuit system.

Therefore, the above-mentioned non-destruction degree can be easily improved by increasing the current amplification ratio $h_{FE}$. In other words, the non-destruction degree can be made greater by increasing $h_{FE}$.

Here, in an area sensor corresponding to HD (High Division), namely high vision, since $C_{tot}$=10 [pF] , $C_v$=2.5 [pF] , for example, for making the non-destruction degree 0.90 or higher, $h_{FE}$ is required to be 2250 or higher. For obtaining sufficient non-destruction degree, it may be estimated that $h_{FE}$ is required to be 2000 or higher.

In contrast, in the prior art, for example, in homo-junction BPT, $h_{FE}$ is about 1000, and hence no sufficient non-destruction degree can be obtained, while in the semiconductor device of the preferred embodiments, excellent non-destruction degree can be obtained because $h_{FE}$ can be made sufficiently great.

Further, desirably, the non-destruction degree should be 0.98 or higher. In this case, $h_{FE}$ is required to be about 10000 or more, but it is difficult to obtain such a value in the homo-junction BPT of the prior art.

In the embodiment shown in Fig. 16, an area sensor was exemplified, but the present invention is also applicable to a line sensor as a matter of course.

Also, for the transistor, BPT as described in the second and third embodiments can be employed.

Referring now to Fig. 1, the fourth embodiment of the semiconductor device of the present invention is described.

In this embodiment, similarly as in the first embodiment, the above-mentioned thin film 30 is formed extremely thinly (thinner than the MIS structure BPT of the prior art) so that there may be little difference in tunnel probability both of the carriers of positive holes and electrons. At least positive holes contribute sufficiently as the carriers of current, and the positive holes passed through said thin film 30 are impeded by the polycrystalline layer 8.

30 is a thin film, and said thin film 30 comprises a thin insulation material for flowing tunnel current therethrough.

In a polycrystalline silicon, in the region (b) shown in Fig. 5, when the grain size of the polycrystal becomes smaller, the quantum effect as described in detail below will occur.

More specifically, for example, when a $n^+$ type polycrystalline silicon is considered, the state in which free electrons are confined within one grain because of the potential barrier formed at its grain boundary may be realized. As the result, fine particles will behave as if like a three-dimensional potential well formed by the grain boundary, and the electrons ordinarily existing continuously in the conduction band will exist scattered by such well. When the above-mentioned well is approximated as a cube with one side of $\underline{a}$, the energy of electrons existing at the conduction band may be represented by the following formula:

$$E_{n1,n2,n3} = \frac{\pi^2 \hbar^2}{2a^2} \left\{ \frac{n_1^2 + n_2^2}{m_t} + \frac{n_3^2}{m_\ell} \right\} \tag{14}$$

Here, $m_t$, $m_\ell$ are respectively the longer axis and shorter axis effective masses of the electrons, and $n_i$ is an integer.

When the film thickness of the polycrystalline silicon layer is made, for example, 10nm (100 Å) the above-mentioned formula (14) becomes as follows:

$$E_{n1,n2,n3} = 4 \times \{5 \ (n_1^2 + n_2^2) + n_3^2\} \qquad \ldots (15)$$
$$[meV]$$

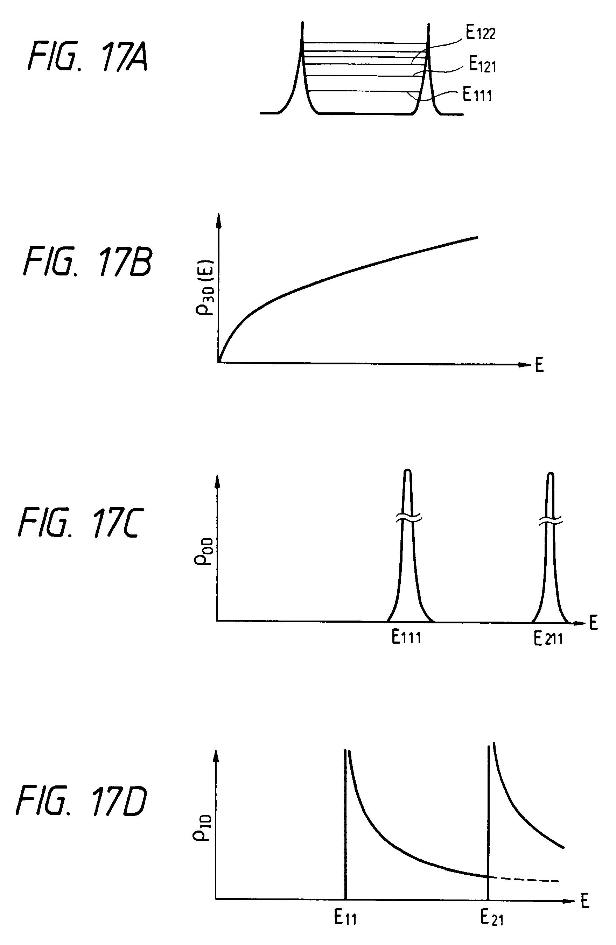

Fig. 17A shows schematically the manner of quantization of the energy of electrons.

As shown in the same Figure, the energy of the electrons is dispersed in the conduction band ($E_{111}$, $E_{121}$, $E_{122}$, etc.). For example, supposing that they follow the above formula (15), when one side $\underline{a}$ of the above-mentioned well is a=10nm (100 Å), the lowest energy (base energy) of the electrons will be higher by 20 [meV] than the conduction band. The electrons of the impurities introduced into the polycrystalline silicon will embed successively this level.

Fig. 17B shows the state density $P_{3D}$ of an ordinary semiconductor of the prior art versus energy F. By three-dimensional quantization, the state density $P_{0D}$ will take a scattered value at energy $E_{111}$, $E_{211}$ as shown in Fig. 17C.

Having described above by referring to the well as a cube, also in the case of a columnar shape, quantization is effected as its dimensions become smaller. In this case, as shown in Fig. 17D, a scattered state density $P_{1D}$ is possessed at the energy $E_{11}$, $E_{21}$. More specifically, although electrons can be filled continuously for energy under crystalline state, only incontinuously energy of electrons can be taken by quantization, resulting in change of the Fermi level of the polycrystalline silicon. Thus, also in the materials having the same impurity density, as the well becomes columunar, cubic, the energy level of the electrons will be scattered (Fig. 17C), and when the electrons are filled at this level, if one side is of the same size, the electrons exist even to the place of the cubic material with the highest energy. In other words, in the case of a cubic body, the Fermi level becomes the highest. To further add, in quantization of cubic body, columnar body, the quantization effect will be greater as the dimensions are smaller.

According to the experimental data, with a film thickness of the polycrystal layer being about 5 to 10nm (50 to 100 Å), the change in Fermi level can be sufficiently seen. With a thickness of 50nm (500 Å) or higher, there is substantially no effect, and the quantization effect occurs with a thickness of 30nm (300 [Å]) or less.

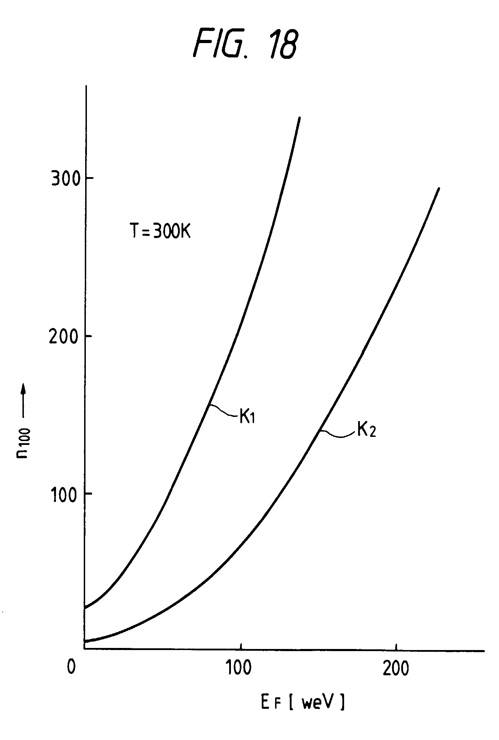

Fig. 18 shows the simulation results of the number of electrons $n_{100}$ filled in the well of a cube with one side of 10nm (100 Å) calculated for the change in Fermi energy $E_F$. The curve $K_1$ shows the case of a crystal, and the curve $K_2$ the case when quantized. However, Fermi energy on the axis of abscissa is the energy value measured from the bottom of the conduction band, and it can be understood from this Figure that Fermi energy will be introduced into the conduction band as the electrons are increased. Fermi energy will exist on the conduction band, as the impurity concentration is increased, and the dimensions of the cubic body are smaller.

When the polycrystalline silicon is of the P-type conduction type, Fermi level exists within the valence electron band.

On the other hand, the upper limit and the lower limit of the impurity concentration is determined by the position of the region (b) in Fig. 4, and the region (b) is the most desirable. Since this is determined from the size of the grains of the polycrystal and the interface level of the grain boundary, it should be properly determined from the experimental results. If the size of grain becomes smaller, the region (b) will be shifted toward the higher concentration side.

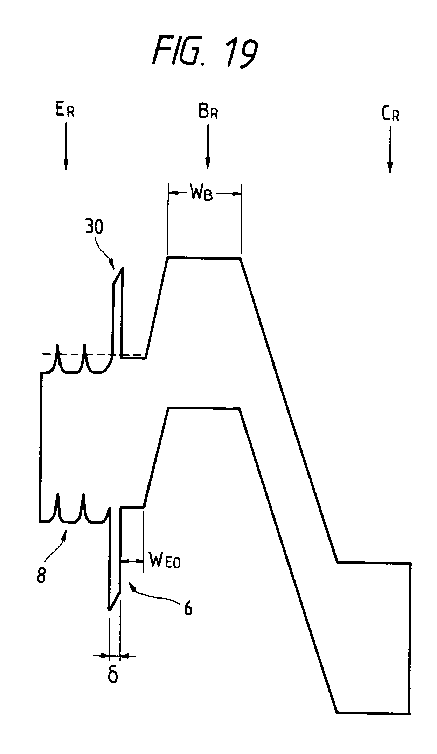

Fig. 19 shows a potential diagram along the line A-A' in Fig. 1.

In Fig. 19, $W_B$ shows the neutral region width of base, $W_{EO}$ the neutral region width of the emitter and $\delta$ the thickness of tunnel ultra-thin film.

To summarize, the most important point in the present embodiment resides in small grain of the polycrystal in the $n^+$ emitter region 6 and the polycrystal layer 8 to give rise to the quantization effect, giving different height of Fermi level, whereby the region of the polycrystal layer 8 becomes a barrier against the positive holes injected from the base and therefore diffusion of positive holes is impeded to reduce base current. The tunnel thin film 30 is formed in a ultra-thin film (approximately 1nm (10 Å) or less) so that the both carriers of electrons and positive holes may show the tunnel phenomenon, and the emitter resistance is also lowered.

The greatest characteristic function of the above-mentioned thin film 30 is separation of the polycrystal layer 8 from the $n^+$ region 6 which is a single crystal, simultaneously with flattening of the interface, and also effects stabilization of the polycrystal layer 8.

More specifically, as described above, for example, when surface washing is completely effected by sputtering, heat treatment, etc. on the $n^+$ region 6 which is merely a single crystal as in the prior art structure shown in Fig. 7A to deposit the polycrystal layer 8 under the surface state without naturally oxidized film, a crystal with about a grain size of polycrystal is epitaxially grown on the single crystal, whereby the interface with the inherent single crystal (B-B' in Fig. 7A) changes to become wavy (or epitaxially grown thinly, followed by becoming wavy), and no constant shape can be always maintained. If the cleaning process on the surface is insufficient and a polycrystal is deposited on the naturally oxidized film and subjected to heat treatment at 1000 °C or higher, the oxide film may be partially broken to effect locally epitaxial growth. In an extreme case, the naturally oxidized film becomes shaped like ball, and the polycrystal recrystallized in single crystals.

Thus, in the case of the prior art structure, all of the interfaces between single crystal and polycrystal become unflat, thereby causing variance in characteristics of BPT to occur.

More specifically, when the carriers injected from the base into the emitter are recombined, the emitter becomes internally nonuniform, and therefore in individual BPT prepared, the base current values are not constant, whereby variance between the respective BPT becomes larger.

In the embodiment shown in Fig. 7B, the thin film 30 is formed on the $n^+$ region 6 which is a single crystal, and the polycrystal layer 8 formed on said thin film (silicon oxide film in this embodiment), and therefore its interface is flat on the atomic order. The polycrystalline 8, which is deposited through the stable thin film 30, is not susceptible to rearrangement of the polycrystal by heat treatment and also stable in the later heat treatment. In micro-crystal Si, amorphous Si, etc. of the prior art (deposition temperature 100 to 300 °C), their characteristics are readily changed by heat treatment at 400 to 600 °C, whereby deterioration of current amplification ratio $h_{FE}$ will readily occur.

In the present embodiment, because the crystal is a polycrystal, the deposition temperature becomes higher. For example, in polycrystalline Si, the temperature is about 550 to 650 [°C], the crystal grain size is large on the surface of the polycrystal, but substantially no hydrogen is contained, and there is little in change of crystal grain size in subsequent steps and also no change by elimination of hydrogen will occur. However, it has been confirmed that the grain size in the vicinity of the interface with $SiO_2$ is small 5 to 10nm (50 to 100 Å). In the case of the polycrystalline Si in the present embodiment, it can stand sufficiently a temperature up to 900 [°C] to give an extremely stable BPT.

Since the interface of the polycrystal layer 8 exists at the interface with the thin film 30, the interface with the emitter region which is a single crystal is extremely flat. This exists an extremely important factor in stabilizing the BPT characteristics.

As is apparent from the above description, the material of the above-described thin film 30 is required to be stable, and therefore should be desirably chemically stable materials such as $SiO_2$, $Si_3N_4$, SiC, $Al_2O_3$, etc. To add further, the interface between the thin film 30 and the single crystal is also extremely important, and the recombination level of the interface is required to be made low.

In the embodiment shown in Fig. 19, the thickness $W_{EO}$ and the concentration Ni of the emitter region $E_R$ are also important factors for reducing base current. Fig. 19 shows the potential diagram at the cross-section A-A' corresponding to the present embodiment in Fig. 1, and in the same Figure, $E_R$ shows the emitter region, $B_R$ the base region, and $C_R$ the collector region.

Next, the process for preparation of the semiconductor devices of the present embodiment shown in Fig. 1 is described.

(1) On a substrate 1 of a predetermined conduction type (p-type or n-type) is formed an $n^+$ embedded region 2 with an impurity concentration of $10^{15}$ to $10^{19}$ [cm$^{-3}$] by ion injection (or impurity diffusion, etc.) of As, Sb, P, etc.

(2) By epitaxial technique, etc. an n-type region 3 with an impurity concentration of $10^{14}$ to $10^{17}$ [cm$^{-3}$] is formed.

(3) An $n^+$ region 7 for reducing the resistance of the collector (with an impurity concentration of $10^{17}$ to $10^{20}$ [cm$^{-3}$]) is formed.

(4) An insulation film 102 for element separation is prepared by the selective oxidation method or the CVD method, etc.

(5) In the active region, a $p^+$ region 5 and a p region 4 which is the base region are formed by the ion injection method, etc.

(6) After opening of an emitter contact on the insulation film 101, an $n^+$ emitter region doped with As, Sb, P, etc. (impurity concentration $5 \times 10^{17}$ to $5 \times 10^{20}$ [cm$^{-3}$]) 6 is formed by the ion injection method or the thermal diffusion method.

(7) A thin film 30 is prepared by oxidation at lower temperature of 500 °C to 650 [°C] or by thermal oxidation by rapid thermal acceleration (RTA).

(8) After deposition of polycrystalline Si doped to $n^+$ according to the LPCVD method, and introduction of impurities by ion injection, diffusion, etc., it is subjected to patterning.

(9) An insulation film 103 is deposited, which is annealed and then subjected to opening of contact.

(10) An Al-Si (1%) which becomes the electrode 200 is subjected to sputtering, followed by patterning of the Al-Si.

(11) After alloy formation of the Al-Si electrode, a passivation film is formed.

According to the procedure as described above, the BPT is completed.

As the above-mentioned thin film 30, a silicon oxide film is the optimum, because it can be easily formed at low temperature, but an insulation film such as silicon nitride film, alumina film, etc. may be also employed.

Also, by use of SiC, etc., a structure which becomes the tunnel type barrier may be formed. For example, SiC, as compared with Si has a conduction band energy difference $\Delta Ev=0.53$ [eV], a valence electron band difference $\Delta Ec=0.55$ [eV] and a band gap $Eg=2.2$ [eV], and when both SiC and Si are junctioned stepwise in n-type, it becomes to have a structure different from the semiconductor/insulator junction.

With the structure shown in Fig. 13C, tunnel probability of electrons, positive holes can be made greater according to film thickness, whereby the electron current of positive holes, electrons can be made greater. With the structure in Fig. 13B, a hetero-structure similar to that of the prior art is obtained, through which only one of the carriers can be passed. In the present embodiment, both positive holes and electrons are passed and one of the carriers is impeded by the polycrystal. Si may be monocrystal, polycrystal, or amorphous.

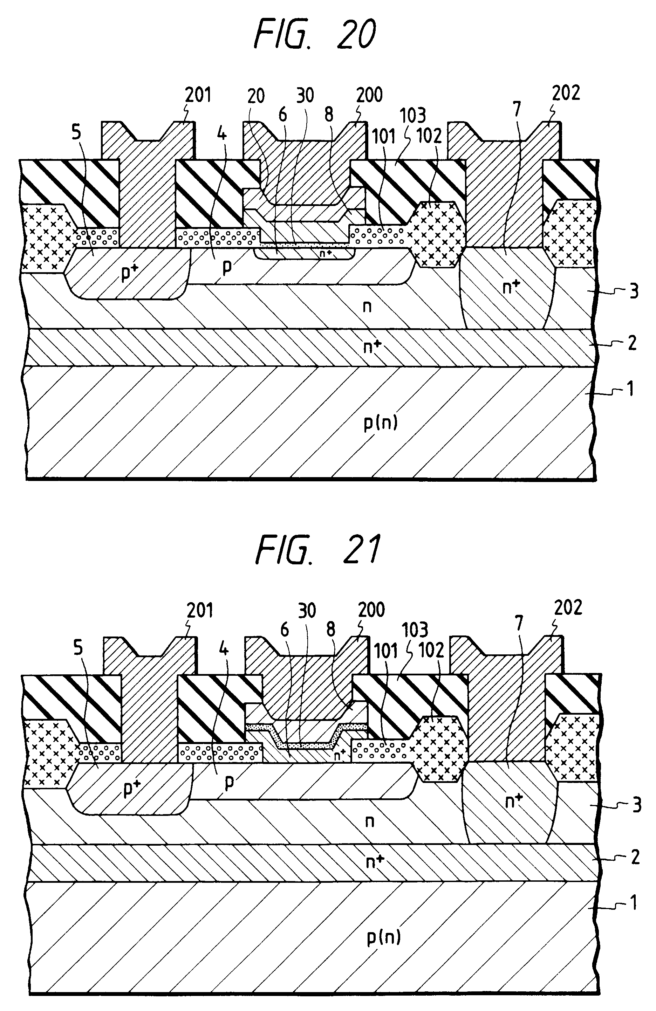

Fig. 20 shows a semiconductor device according to the fifth embodiment of the present invention. In this embodiment, on the polycrystal layer 8 having the quantum effect is further formed a low resistance layer 20, and the grain size in the region of said low resistance layer 20 is set greater as compared with that in the region of the polycrystalline layer 8, thereby effecting lower resistance.

As is apparent from Fig. 4, the resistance in the region (b) is extremely sensitive to grain size, and the resistance of the metal electrode at the contact side is lowered even at the same concentration to reduce the emitter resistance.

In this case, in the preparation steps, first a polycrystal layer 8 is deposited to a thickness corresponding to the thickness of the polycrystal layer 8 and the low resistance layer 20 superposed, and then the region corresponding to the low resistance layer 20 is made amorphous by ion injection, followed by heat treatment to make the grain size only in said amorphous region greater.

Other than such preparation method, the above-mentioned low resistance layer 20 may be made amorphous with As, Sb, P, etc. which is n-type impurity, and then heat treatment may be performed, or alternatively it may be differently made amorphous with Ge, Si, etc. rather than injection of an impurity. However, the grain size of the polycrystal layer 8 will become larger, unless the heat treatment is carried out at 900 °C or lower.

As another preparation method, there is also a method in which a polycrystalline silicon containing initially an impurity may be deposited, and only the above-mentioned low resistance layer 20 is made amorphous by ion injection with Ge, Si, etc., followed by heat treatment.

It is critical that the amorphous region after ion injection should be made so as not to reach the interface between the polycrystalline silicon and the single crystalline silicon.

Other constitutions are the same as in the first embodiment as described above, and redundant description is omitted.

Fig. 21 shows the sixth embodiment of the present invention.

In this embodiment, an $n^+$ emitter region 6 is formed by epitaxial growth on the P-type region 4 as the base region, and a thin film 30 for tunnel and a polycrystal layer 8 formed thereon.

With such constitution, since the n$^+$ emitter region 6 is in contact in plane with the base region, diffusion of the carriers into the base region becomes smaller, whereby the lateral direction current of the emitter current becomes smaller to an advantage of the finely formed BPT.

Other constitutions are the same as in the above-described first embodiment, and redundant description is omitted.

Referring to Fig. 1, the seventh embodiment of the semiconductor device of the present invention is described.

Also, in this embodiment, the above-mentioned thin film 30 is formed extremely thinly (thinner than the MIS structure BPT of the prior art) to make substantially no difference between the both tunnel probabilities of the carriers of positive holes and electrons. At least positive holes also contribute sufficiently as the carriers of current, and the positive holes passed through said thin film 30 are impeded by the polycrystal layer 8.

The polycrystal silicon of this embodiment employs the impurity concentration ratio of the region (c), and the depletion layer width W at the grain boundary is represented approximately by the following formula:

$$W = \frac{2Q_t}{Ni} \qquad (16)$$

Ordinarily, tunnelling phenomena of electrons and positive holes are liable to occur at a film thickness of the thin film of 5nm (50 Å) or less, for example, if the trap level density $Q_t$ is made $5 \times 10^{12}$ [cm$^{-2}$], the impurity concentration Ni is required to be $4 \times 10^{19}$ [cm$^{-3}$] or higher. If the film thickness of the tunnel thin film is made 5nm (50 Å) or less, the impurity concentration Ni depends on $Q_t$, but corresponds to the region (c), when the following relationship is valid:

$$Ni \geqq \frac{2Q_t}{5 \times 10^{-7}} = 4 \times 10^6 Q_t \text{ [cm}^{-3}] \qquad (17)$$

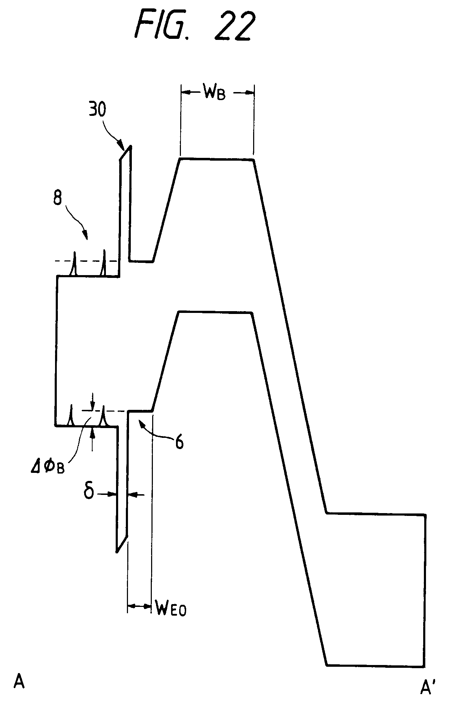

Fig. 22 shows the potential diagram in this embodiment at the cross-section along the line A-A' in Fig. 1, and the base width is represented by $W_B$, the single crystal emitter depth by $W_{EO}$ and the film thickness of the ultra-thin film by $\delta$. What is the most important is the height $\Delta\phi_B$ of the barrier between the single crystal emitter and the polycrystal emitter.

The height of the barrier $\Delta\phi_B$ reduces the base current as the barrier of the positive holes injected from the base region. The positive holes injected from the base region, after passing through the tunnel film, is further reduced to $\exp(-\Delta\phi_B/kT)$, and becomes a value of e$^{-1}$ if the height $\Delta\phi_B$ of the above-mentioned barrier is kT. Accordingly, if the height $A\phi_B$ of said barrier is kT or higher which is the heat energy at said temperature T, there ensues the effect of base current reduction.

The height of the barrier $\Delta\phi_B$, in the present embodiment, is created by the difference in Fermi level between the emitter region of single crystal and the polycrystal region.

Due to such effect, a hetero-junction effect arises in the emitter region, whereby increase of current amplification ratio $h_{FE}$ can be effected.

As a problem in designing, the above-mentioned constitution can be realized by making the concentration in the n$^+$ emitter region 6 smaller than that in the polycrystal layer 8.

The relationship between the energy $E_i$ and the Fermi level $E_F$ can be represented approximately by the following formula:

$$\text{n-type semiconductor: } E_F - E_i = kT \ell n \frac{N_D}{n_i} \qquad (18)$$

$$\text{p-type semidonductor: } E_i - E_F = kT \ell n \frac{N_A}{n_i} \qquad (19)$$

Here, $N_D$ and $N_A$ are respectively n-type, p-type impurity densities, and $n_i$ intrinsic semiconductor carrier density.

Whereas, the above formula is the range to which Boltzman's statistic is applicable, but when the carrier density $n_i$ becomes higher concentration, Fermi-Dirac statistic is applied and therefore the above formula cannot be employed.

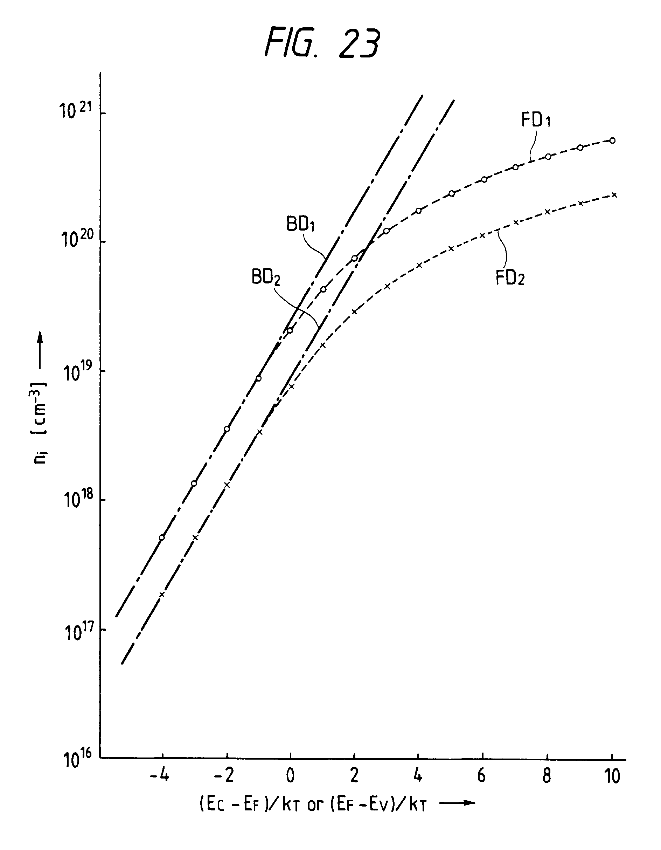

Fig. 23 shows the relationship between Fermi level $E_F$ and carrier density $n_i$ in semiconductor silicon. The axis of abscissa in the same Figure represents energy normalized with kT, namely $(E_F - E_C)/kT$ in the case of n-type semiconductor and $(E_V - E_F)kT$ in the case of p-type semiconductor, respectively, and its axis of ordinate carrier density $n_i$ [cm$^{-3}$]. $n_i$ is a value approximately equal to impurity density at normal temperature.

In the formula showing the above-mentioned axis of abscissa, $E_C$, $E_V$ are respectively energies of the conduction band end, the valence electron band end, and the fact that the normalized energy is zero means that Fermi level $E_F$ coincides with $E_C$, $E_V$. As compared with such coincidence, if the carrier density $n_i$ is higher, it means that $E_F$ is not in the forbidden band but incorporated into the conduction band in n-type, and into the valence electron band in p-type. The impurity concentration at this time becomes $2.1 \times 10^{19}$ [cm$^{-3}$] in the case of n-type and $8 \times 10^{18}$ [cm$^{-3}$] in the case of p-type.

In Fig. 23, the lines shown by chain lines (curved line BD$_1$, straight line BD$_2$) are examples to which Boltzman's statistic is applied, and the lines shown by broken lines (curved line $FD_1$, straight line $FD_2$) are examples to which Fermi-Dirac statistic is applied, and difference occurs between the both statistics in the range where the normalized energy is larger than 1. More specifically, when the normalized energy is larger than 1, Fermi energy cannot be correctly evaluated unless Fermi-Dirac statistic is used. In the same Figure, the plots of the symbol O show the case of n-type semiconductor, and the plots of x the case of p-type semiconductor.

The difference between n-type semiconductor and p-type semiconductor occurs due to difference in band structure, effective mass. Of course, with other materials, this value will be different.

When the concentration in the vicinity of the emitter base region is defined as $N_{E1}$, and that in the higher concentration polycrystal region as $N_{E2}$, then from the above formula (18), the following relationship is approximately valid:

$$N_{E2} \geq eN_{E1} \qquad (20)$$

where e is a natural number (= 2.718). Under this condition, $\Delta\phi_B \geq kT$. Correctly, $N_{E1}$, $N_{E2}$ will be determined by use of the data in Fig. 23.

When the relationship $\Delta\phi_B \geq 2kT$ is valid, the relationship becomes $N_{E2} \geq e^2 N_{E1}$.

In the present embodiment, the thickness $W_{EO}$ and the concentration $N_D$ in the emitter region $E_R$ shown in Fig. 22 are also important factors for reducing the base current. In the same Figure, $E_R$ represents emitter region, $B_R$ base region, and $C_R$ collector region.

Ordinarily, the above-mentioned thin film 30 should preferably have a thickness 2nm (20 Å) or less. Since it is smaller as compared with the thickness of the n$^+$ emitter region 6, the distance $W_E$ from the emitter-base junction to the polycrystal layer 8 is represented by:

$$W_E \simeq W_{EO} + \delta \qquad (21)$$

thus becoming substantially equal to $W_{EO}$.

On the other hand, another important factor in the present embodiment, namely inhibition of the minority carriers injected from the base is effected at the interface between the polycrystal layer 8 and the thin film 30. Of course, the tunnel probability of electrons and positive holes in tunnel film is greater for electrons, and therefore the above-mentioned inhibition effect has also occurred simultaneously with said tunnel effect.

Also in the case of the base current of the BFT according to the present embodiment, it becomes primarily the recombination current represented by the above formula (7), and the maximum value $h_{FEmax}$ of current amplification ratio in this case is as follows:

$$h_{FEmax} = 2 \left(L_n/W_B\right)^2$$

whereby the upper limit of $h_{FE}$ is determined only by the base conditions. $h_{FE}$ according to the present embodiment is 10000 or higher.

Fig. 12 shows the relationship between impurity concentration $N_D$ in the above-mentioned n$^+$ emitter region 6 and the diffusion distance $L_P$ of minority carriers (positive holes) and the life $\tau_P$ of said minority carriers. From this relationship, the emitter depth should be preferably made at least about 1/5 of the diffusion distance of positive holes.

Next, the process for preparation of the semiconductor device of the present embodiment shown in Fig. 1 is described.

(1) On a substrate 1 of a predetermined conduction type (p-type or n-type) is formed an n$^+$ embedded region 2 with an impurity concentration of $10^{15}$ to $10^{19}$ [cm$^{-3}$] by ion injection (or impurity duffusion, etc.) of As, Sb, P, etc.

(2) By epitaxial technique, etc. an n-type region 3 with an impurity concentration of $10^{14}$ to $10^{17}$ [cm$^{-3}$] is formed.

(3) An n$^+$ region 7 for reducing the resistance of the collector (with an impurity concentration of $10^{17}$ to $10^{20}$ [cm$^{-3}$]) is formed.

(4) An insulation film 102 for element separation is prepared by the selective oxidation method or the CVD method, etc.

(5) In the active region, a p$^+$ region 5 and a p region 4 which is the base region are formed by the ion injection method, etc.

(6) After opening of an emitter contact on the insulation film 101, an n$^+$ mitter region doped with As, Sb, P, etc. (impurity concentration 5 x $10^{17}$ to 5 x $10^{19}$ [cm$^{-3}$] 6 is formed by the ion injection method or the thermal diffusion method.

(7) A thin film 30 is prepared by oxidation at lower temperature of 500 to 650 [C°] or by thermal oxidation by rapid thermal acceleration (RTA).

(8) After deposition of a polycrystalline Si doped to n$^+$ according to the LPCVD method, n-type impurity of As or P is introduced by the ion injection method at high concentration (5 x $10^{19}$ [cm$^{-3}$] or higher), and subjected to heat treatment for activation. However, heat treatment is carried out at low temperature (850 [°C] or lower) so that it will not be diffused to the n$^+$ emitter layer 6 below the polycrystalline silicon layer, or within a short time by rapid thermal heating. Then, the polycrystalline layer 8 is subjected to patterning to form an emitter electrode.

(9) An insulation film 103 is deposited, which is annealed and then subjected to opening of contact.

(10) An Al-Si (1%) which becomes the electrode 200 is subjected to sputtering, followed by patterning of the Al-Si.

(11) After alloy formation of the Al-Si electrode, a passivation film is formed.

According to the procedure as described above, the BPT of the present embodiment is completed.

What is important in the above-described process concerns preparation of the thin film 30 of (7) and setting of the emitter concentrations of (6), (8). The single crystalline emitter in (6) is required to set the depth of junction and the concentration so as to make the base current determined by the above formula (10) minimum.

While shallowing by making higher the emitter concentration is one means, if said concentration becomes $10^{19}$ [cm$^{-3}$] or higher, the band-tailing effect with an impurity occurs to increase minority carriers in proportion to exp ($\Delta E/kT$), whereby the base current represented by the above formula (10) begins to increase. When the concentration becomes higher, it becomes difficult to effect shallow junction also in the preparation process. This is because the impurity diffusion coefficient becomes larger as the impurity concentration is higher.

Therefore, the emitter region which is a single crystal is made to have its concentration of a junction depth in the vicinity of $10^{19}$ [cm$^{-3}$].

On the other hand, the concentration of the polycrystal layer is set at least higher by about one cipher than the emitter region. In the BPT having no tunnel thin film of the prior art, diffusion occurred during heat treatment, thereby making preparation difficult, but in the present embodiment, due to the presence of the ultra-thin film 30, the diffusion speed of the impurity in said thin film is slower by 1 to 2 cipher as compared with single crystal, thus solving such problem.

On the other hand, diffusion of an impurity with a grain boundary of polycrystal being interposed is faster by 1 to 2 cipher as compared in single crystal, whereby stable preparation of BPT can be performed.

Other characteristic functions of the above-mentioned thin film 30 are separation of the polycrystal layer 8 from the n$^+$ region 6 which is the single crystal of the emitter region 6, simultaneously with flattening of its interface, and also effecting stabilization of the polycrystal layer 8.

More specifically, when a polycrystal layer 8 is formed on the n$^+$ region 6 which is a mere single crystal, the crystal which has about the size of the polycrystal on the single crystal is epitaxially grown, whereby the interface with inherent single crystal will change to become wavy and a constant shape cannot be always maintained. In this case, if a polycrystal is deposited on the naturally oxidized film and subjected to heat treatment, the oxide film will be partially broken, whereby epitaxial growth occurs locally, or in an extreme case, the naturally oxidized film will become shaped like ball, resulting in recrystallization of the polycrystal into single crystal.

Thus, in the case of all of the prior art structures, the interface between the single crystal and the polycrystal becomes unflat, thereby causing variance of characteristics of BPT.

More specifically, when the carriers injected from the base into the emitter are recombined within the emitter, the emitter becomes nonuniform internally, and therefore in the individual BPT prepared, the base current value is not constant, but variance between the respective BPT becomes larger.

In the present embodiment, the thin film 30 is formed on the n$^+$ region 6 which is a single crystal, and the polycrystal layer 8 formed on said thin film (silicon oxide film in this embodiment), and therefore its interface is flat on the atomic order. The polycrystal layer 8, which is deposited through the stable thin film 30, is not susceptible to rearrangement of the polycrystal by heat treatment and also stable in the later heat treatment. In micro-crystal Si, amorphous Si, etc. of the prior art (deposition temperature 100 to 300 [°C]), their characteristics are readily changed by heat treatment at 400 to 600 [°C], whereby deterioration of current amplification ratio $h_{FE}$ will readily occur.

In the present embodiment, because the crystal is a polycrystal, the deposition temperature becomes higher. For example, in polycrystalline Si, the temperature is about 550 to 650 [°C], the crystal grain size is large, and in addition substantially no hydrogen is contained, and there is little in change of crystal grain size in subsequent steps and also no change by elimination of hydrogen will occur. In the case of the polycrystalline Si, it can stand sufficiently a temperature up to 900 [°C] to give an extremely stable BPT.

Since the interface of the polycrystal layer 8 exists at the interface with the thin film 30, the interface with the emitter region which is a single crystal is extremely flat. This is an extremely important factor in stabilizing the BPT characteristics.

As is apparent from the above description, the material of the above-described thin film 30 is required to be stable, and therefore as described previously should be desirably chemically stable materials such as $SiO_2$, $Si_3N_4$, SiC, $Al_2O_3$, etc. To add further, the interface between the thin film 30 and the single crystal is also extremely important, and the recombination level of the interface is required to be made low.

Also, by use of SiC, etc., the structure may be made a tunnel type barrier. For example, SiC as compared with Si has a conduction band energy difference $\Delta E_v = 0.53$ [eV], a valence electron band difference $\Delta E_C = 0.55$ [eV] and a band gap $E_g$ = 2.2 [eV], thus having a different structure from semiconductor/insulator junction when SiC and Si are both n-types and junctioned stepwise.

As the barrier height $\phi_B$ of the thin film 30 for tunnel is lower, the direct tunnel probability becomes higher, whereby more current will flow. That is, the emitter resistance is lowered to give a preferable device. As the material for said thin film 30, those which are stable and narrow in forbidden band width are desirable.

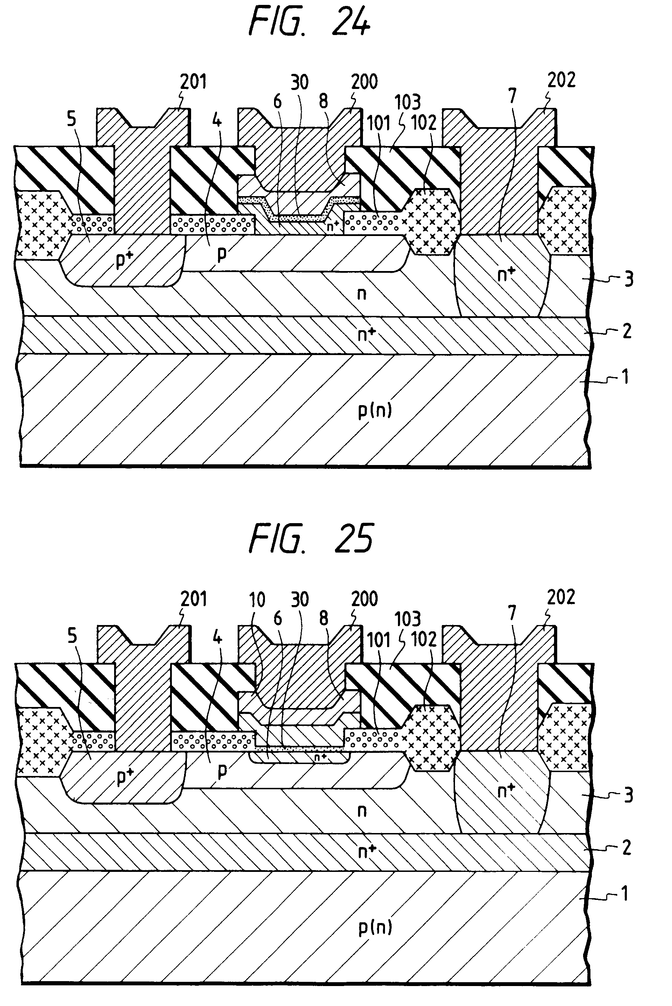

Next, Fig. 24 shows a semiconductor device according to the eighth embodiment of the present invention. This embodiment has the emitter region 6 in the above-described first embodiment formed by epitaxial growth, and further a thin film 30 for tunnel and a high concentration polycrystal layer 8 laminated thereabove. With such constitution, the emitter region 6 is in contact in plane with the base region, and most of diffusion of carriers from the emitter region to the base region is inhibited, whereby the lateral direction current in the emitter region is small and the influence by the dimensional precision on current amplification ratio can be reduced. Accordingly, it is useful for application to fine formation of semiconductor device, highly integrated photoelectric converting device.

Other constitutions, actions are the same as in the seventh embodiment as described and therefore redundant description is omitted.

Fig. 25 shows the ninth embodiment of the present invention.

In this embodiment, between the high concentration polycrystal layer 8 and the electrode 200 in the seventh embodiment, a so called barrier metal layer 10 of TiN, TiW, Mo, W, etc. which acts as the diffusion barrier is formed to inhibit the reaction between the polycrystal and the electrode (Al), whereby a semiconductor which is stable and little in variance can be prepared. Since the electrode (Al) is susceptible to diffusion within the polycrystal, it may have influences on the characteristics of BPT in some cases.

Other constitutions and actions are the same as in the above-described first embodiment, and therefore redundant description is omitted.

The BPT's according to the first to the ninth embodiments as described above were found to have extremely stable transistor characteristics.

The fourth to the ninth embodiment as described above can be applied to the transistors to be used for the sensor portion of the electronic device as shown in Fig. 16 similarly as the first to the third embodiments, as a matter of course.

## Claims

1. A semiconductor device comprising:

   a collector region (3,7) of first conductivity type;
   a monocrystalline base region (4,5) of second conductivity type;
   a monocrystalline emitter region (6) of the first conductivity type providing at an interface with said base region (4,5) an emitter-base junction in single crystal;
   a thin film (30) provided on said emitter region; and
   a polycrystalline layer (8) laminated on said thin film (30);
   which semiconductor device is characterised in that:
   said thin film (30) is so thin that it results in an appreciable tunnel current flow for both majority and minority carriers, the tunnelling probabilities of both majority and minority carriers being substantially equal to each other; and
   said polycrystalline layer (8) provides a potential barrier to the flow of carriers injected from said base region (4,5) thereby to reduce base current and increase current amplification ratio.

2. A semiconductor device as claimed in claim 1 wherein said potential barrier is located at the grain boundaries (Bc) of said polycrystalline layer (8).

3. A semiconductor device according to claim 2, wherein

   said polycrystalline layer has a resistance value, the inverse of which is either approximately constant being independent of temperature, or alternatively an increasing function of temperature.

4. A semiconductor device according to claim 2, wherein the main constituent of said polycrystalline layer (8) is silicon.

5. A semiconductor device according to claim 2, wherein

   said thin film (30) is of thickness not greater than 5nm.

6. A semiconductor device according to claim 2, wherein there is provided

on said polycrystalline layer (8), a semiconductor layer (10) having a band gap narrower than that of said polycrystalline layer (8).

7. A semiconductor device as claimed in claim 1 wherein said potential barrier is a potential barrier between said polycrystalline layer (8) and said emitter region (6) at the interface of said polycrystalline layer (8) and said thin film (30) which is present under the thermal equilibrium condition that the Fermi level of said polycrystalline layer (8) is aligned with the Fermi level of said emitter region (6).

8. A semiconductor device according to claim 7, wherein

said polycrystalline layer (8) has a Fermi level shift consequential to quantum confinement of carriers in the grains thereof.

9. A semiconductor device according to claim 8, wherein

said polycrystalline layer (8) has a thickness and grain size not greater than 30 nm.

10. A semiconductor device according to claim 7, wherein

said polycrystalline layer (8) has an impurity concentration of N, grain size of L, and trap level density $Q_t$ at grain boundaries, satisfying the inequality relation $N < Q_t/L$.

11. A semiconductor device according to claim 7, wherein

said thin film (30) has a thickness not greater than 1 nm.

12. A semiconductor device according to claim 11, having on said polycrystalline layer (8), a lower resistance polycrystalline layer (20) having a greater grain size.

13. A semiconductor device according to claim 7, wherein

said emitter region has an impurity concentration of $N_{E1}$, and said polycrystalline layer has an impurity concentration of $N_{E2}$, wherein they meet relation $N_{E2} > e.N_{E1}$ wherein e denotes a natural number.

14. A semiconductor device according to any of claims 1, 2 or 7, wherein

said emitter region (6) has a thickness not greater than the diffusion length of minority carriers injected from said base region (4,5).

15. A semiconductor device according to claim 7, wherein

said thin film (30) has a thickness not greater than 2 nm.

16. A semiconductor device according to any of claims 1, 2 or 7, wherein

said thin film (30) is of $SiO_2$, $Si_3N_4$, SiC, or $Al_2O_3$.

17. A semiconductor device according to claim 7, wherein

a barrier metal layer (10) is located between said polycrystalline layer (8) and an electrode (200).

18. A semiconductor device according to claim 17, wherein

said barrier metal layer (10) is of TiN, TiW, Mo, or W.

19. A semiconductor device according to any of claims 1, 2 or 7, wherein

said emitter region (6) is an epitaxial layer disposed on said base region (4).

20. An electronic apparatus incorporating said semiconductor device according to any of claims 1, 2 or 7 as a photoelectric conversion device.

**Patentansprüche**

1. Halbleiterbauelement, das

   eine Kollektorzone (3,7) eines ersten Leitungstyps,
   eine monokristalline Basiszone (4,5) eines zweiten Leitungstyps,
   eine monokristalline Emitterzone (6) des ersten Leitungstyps, die an einer Grenzfläche zu der Basiszone (4,5)
   einen Emitter-Basis-Übergang in einem einzelnen Kristall bildet,
   einen auf die Emitterzone aufgebrachten Dünnfilm (30) und
   eine auf den Dünnfilm (30) aufgeschichtete polykristalline Schicht (8) aufweist,
   dadurch gekennzeichnet, daß
   der Dünnfilm (30) so dünn ist, daß er sowohl für Majoritätsträger als auch für Minoritätsträger einen merklichen Tunnelstromfluß ergibt, wobei die Tunnelwahrscheinlichkeiten der Majoritätsträger und der Minoritätsträger aneinder im wesentlichen gleich sind, und
   die polykristalline Schicht (8) für den Fluß von aus der Basiszone (4,5) injizierten Trägern eine Potentialbarriere bildet, um dadurch den Basisstrom zu verringern und das Stromverstärkungsverhältnis zu erhöhen.

2. Halbleiterbauelement nach Anspruch 1, in dem die Potentialbarriere an den Korngrenzen (Bc) der polykristallinen Schicht (8) liegt.

3. Halbleiterbauelement nach Anspruch 2, in dem die polykristalline Schicht einen Widerstandswert hat, dessen Kehrwert entweder unabhängig von der Temperatur nahezu konstant ist oder alternativ eine ansteigende Funktion der Temperatur ist.

4. Halbleiterbauelement nach Anspruch 2, in dem der Hauptbestandteil der polykristallinen Schicht (8) Silizium ist.

5. Halbleiterbauelement nach Anspruch 2, in dem der Dünnfilm (30) eine Dicke von nicht mehr als 5 nm hat.

6. Halbleiterbauelement nach Anspruch 2, in dem auf die polykristalline Schicht (8) eine Halbleiterschicht (10) mit einem Bandabstand aufgebracht ist, der schmäler als derjenige der polykristallinen Schicht (8) ist.

7. Halbleiterbauelement nach Anspruch 1, in dem die Potentialbarriere eine Potentialbarriere zwischen der polykristallinen Schicht (8) und der Emitterzone (6) an der Grenzfläche der polykristallinen Schicht (8) und des Dünnfilmes (30) ist, die unter der termischen Gleichgewichtsbedingung vorhanden ist, daß das Fermi-Niveau der polykristallinen Schicht (8) dem Fermi-Niveau der Emitterzone (6) angeglichen ist.

8. Halbleiterbauelement nach Anspruch 7, in dem die polykristalline Schicht (8) infolge des Quanteneinschlußes von Trägern in deren Körnern eine Fermi-Niveau-Verschiebung hat.

9. Halbleiterbauelement nach Anspruch 8, in dem die polykristalline Schicht (8) eine Dicke und eine Korngröße von nicht mehr als 30 nm hat.

10. Halbleiterbauelement nach Anspruch 7, in dem die polykristalline Schicht (8) eine Fremdstoffkonzentration N, eine Korngröße L und an den Korngrenzen eine Fangstellenpegeldichte $Q_t$ hat, die der Ungleichung $N < Q_t/L$ genügen.

11. Halbleiterbauelement nach Anspruch 7, in dem der Dünnfilm (30) eine Dicke von nicht mehr als 1 nm hat.

12. Halbleiterbauelement nach Anspruch 11, das auf der polykristallinen Schicht (8) eine polykristalline Schicht (20) niedrigen Widerstandes mit einer größeren Korngröße hat.

13. Halbleiterbauelement nach Anspruch 7, in dem die Emitterzone eine Fremdstoffkonzentration $N_{E1}$ hat und die polykristalline Schicht eine Fremdstoffkonzentration $N_{E2}$ hat, die der Beziehung $N_{E2} > eN_{E1}$ genügen, wobei e eine natürliche Zahl ist.

14. Halbleiterbauelement nach einem der Ansprüche 1, 2 oder 7, in dem die Emitterzone (6) eine Dicke hat, die nicht größer als die Diffusionslänge von Minoritätsträgern ist, welche aus der Basiszone (4,6) injiziert sind.

15. Halbleiterbauelement nach Anspruch 7, in dem der Dünnfilm (30) eine Dicke von nicht mehr als 2 nm hat.

16. Halbleiterbauelement nach einem der Ansprüche 1, 2 oder 7, in dem der Dünnfilm (30) aus $SiO_2$, $Si_3N_4$, $SiC$ oder $Al_2O_3$ besteht.

17. Halbleiterbauelement nach Anspruch 7, in dem zwischen der polykristallinen Schicht (8) und einer Elektrode (200) eine Barrierenmetallschicht (10) liegt.

18. Halbleiterbauelement nach Anspruch 17, in dem die Barrierenmetallschicht (10) aus TiN, TiW, Mo oder W besteht.

19. Halbleiterbauelement nach einem der Ansprüche 1, 2 oder 7, in dem die Emitterzone eine auf die Basiszone (4) aufgebrachte epitaxiale Schicht ist.

20. Elektronische Vorrichtung, die als photoelektrisches Wandlerelement das Halbleiterbauelement gemäß einem der Ansprüche 1, 2 oder 7 enthält.


**Revendications**

1. Dispositif à semi-conducteur comprenant :

une zone du collecteur (3, 7) d'un premier type de conductivité ;
une zone de la base monocristalline (4, 5) d'un second type de conductivité ;
une zone de l'émetteur monocristalline (6) du premier type de conductivité fournissant, à une interface avec ladite zone de la base (4, 5), une jonction émetteur-base en monocristal ;
un film mince (30) prévu sur ladite zone de l'émetteur ; et
une couche polycristalline (8) stratifiée sur ledit film mince (30) ;
lequel dispositif à semi-conducteur est caractérisé en ce que :
ledit film mince (30) est si mince qu'il a pour conséquence une circulation de courant à effet tunnel appréciable à la fois pour les porteurs majoritaires et minoritaires, les probabilités de franchissement par effet tunnel à la fois des porteurs majoritaires et minoritaires étant sensiblement égales les unes aux autres ; et
ladite couche polycristalline (8) fournit une couche d'arrêt potentielle à la circulation de porteurs injectés depuis ladite zone de la base (4, 5), pour réduire ainsi le courant de base et augmenter le rapport d'amplification de courant.

2. Dispositif à semi-conducteur selon la revendication 1, dans lequel ladite couche d'arrêt potentielle est située aux joints de grain (Bc) de ladite couche polycristalline (8).

3. Dispositif à semi-conducteur selon la revendication 2, dans lequel

ladite couche polycristalline a une valeur de résistance, l'inverse de celle-ci étant soit approximativement constante en ne dépendant pas de la température, soit sinon une fonction croissante de température.

4. Dispositif à semi-conducteur selon la revendication 2, dans lequel le principal composant de ladite couche polycristalline (8) est le silicium.

5. Dispositif à semi-conducteur selon la revendication 2, dans lequel

ledit film mince (30) est d'une épaisseur n'excédant pas 5 nm.

6. Dispositif à semi-conducteur selon la revendication 2, dans lequel il est prévu

sur ladite couche polycristalline (8), une couche semi-conductrice (10) ayant un espace formant bande plus étroit que celui de ladite couche polycristalline (8).

7. Dispositif à semi-conducteur selon la revendication 1, dans lequel ladite couche d'arrêt potentielle est une couche d'arrêt potentielle entre ladite couche polycristalline (8) et ladite zone de l'émetteur (6) à l'interface de ladite couche polycristalline (8) et dudit film mince (30) qui est présente à la condition d'équilibre thermique qui est que le niveau de Fermi de ladite couche polycristalline (8) soit aligné avec le niveau de Fermi de ladite zone de l'émetteur (6).

8. Dispositif à semi-conducteur selon la revendication 7, dans lequel

ladite couche polycristalline (8) a un décalage de niveau de Fermi consécutif au confinement quantique des porteurs dans les grains de celle-ci.

9. Dispositif à semi-conducteur selon la revendication 8, dans lequel

ladite couche polycristalline (8) a une épaisseur et une taille de grain n'excédant pas 30 nm.

10. Dispositif à semi-conducteur selon la revendication 7, dans lequel

ladite couche polycristalline (8) a une concentration en impuretés de N, une taille de grain de L, et une densité de niveau de séparation $Q_t$ aux joints de grain, satisfaisant à la relation d'inégalité $N < Q_t/L$.

11. Dispositif à semi-conducteur selon la revendication 7, dans lequel

ledit film mince (30) a une épaisseur n'excédant pas 1 nm.

12. Dispositif à semi-conducteur selon la revendication 11, ayant sur ladite couche polycristalline (8) une couche polycristalline (20) de résistance inférieure ayant une taille de grain supérieure.

13. Dispositif à semi-conducteur selon la revendication 7, dans lequel

ladite zone de l'émetteur a une concentration en impuretés de $N_{E1}$, et ladite couche polycristalline a une concentration en impuretés de $N_{E2}$, dans lequel elles satisfont à la relation $N_{E2} > e. N_{E1}$, dans laquelle e désigne un nombre naturel.

14. Dispositif à semi-conducteur selon l'une quelconque des revendications 1, 2 ou 7, dans lequel

ladite zone de l'émetteur (6) a une épaisseur n'excédant pas la longueur de diffusion des porteurs minoritaires injectés depuis ladite zone de la base (4, 5).

15. Dispositif à semi-conducteur selon la revendication 7, dans lequel

ledit film mince (30) a une épaisseur n'excédant pas 2 nm.

16. Dispositif à semi-conducteur selon l'une quelconque des revendications 1, 2 ou 7, dans lequel

ledit film mince (30) se compose de $SiO_2$, $Si_3N_4$, SiC ou $Al_2O_3$.

17. Dispositif à semi-conducteur selon la revendication 7, dans lequel

une couche métallique (10) formant couche d'arrêt est située entre ladite couche polycristalline (8) et une électrode (200).

18. Dispositif à semi-conducteur selon la revendication 17, dans lequel

ladite couche métallique (10) formant couche d'arrêt se compose de TiN, TiW, Mo ou W.

19. Dispositif à semi-conducteur selon l'une quelconque des revendications 1, 2 ou 7, dans lequel

ladite zone de l'émetteur (6) est une couche épitaxiale disposée sur ladite zone de la base (4).

20. Appareil électronique incorporant ledit dispositif à semi-conducteur selon l'une quelconque des revendications 1, 2 ou 7 en tant que dispositif de conversion photoélectrique.

# FIG. 1

*FIG. 2A*

$E_c$

$E_v$

*FIG. 2B*

$B_c$      $B_c$

$E_P$

8

$x$

*FIG. 3A*

$W$

$\phi_B$

$E_c$

$E_g$

$E_v$

*FIG. 3B*

$B_c$      $B_c$

$E_P$    $n_R$    $E_P$

$x$

# FIG. 4

Qt CONSTANT

(a)

L=200Å

L=420Å

(b)

L=1220Å

(c)

logρ (Ω·cm) ⟶

Ni (cm⁻³)

# FIG. 5

# FIG. 6

# FIG. 7A

# FIG. 7B

## FIG. 8A

## FIG. 8B

# FIG. 9

# FIG. 10A

# FIG. 10B

# FIG. 11

## FIG. 12

## FIG. 13A

n-Si          n-Sic

$\phi W$

$\Delta Ec$          $\Delta E_f$

Ec

Ev

$\Delta Ev$          $\Delta Ec + \Delta Ev - \Delta E_f$

## FIG. 13B

n-Si     n-Sic     n-Si

Ec

Ev

## FIG. 13C

n-Si     n-Sic     n-Si

Ec

Ev

EP 0 431 836 B1

# FIG. 14

# FIG. 15

# FIG. 16

FIG. 17A

FIG. 17B

FIG. 17C

FIG. 17D

FIG. 18

# FIG. 19

## FIG. 20

## FIG. 21

# FIG. 22

FIG. 23

## FIG. 24

## FIG. 25